# EUROPEAN PATENT APPLICATION

(11) **EP 4 472 227 A1**
(43) Date of publication of application: **04.12.2024**
(21) Application number: 24162452.7
(22) Date of filing: 08.03.2024
(51) Int. Cl.: H04N 25/532, H04N 25/46, H04N 25/778, H04N 25/78, H01L 27/146

(54) **HYBRID IMAGE SENSORS WITH MULTIMODE SHUTTERS**

(30) Priority: 02.06.2023 US 202318328344
(71) Applicant: Meta Platforms Technologies, LLC, Menlo Park, CA 94025 (US)
(72) Inventor: Tsai, Tsung-Hsun, Menlo Park (US); Bainbridge, Lyle David, Menlo Park (US)
(74) Representative: Murgitroyd & Company

(57) **Abstract**

Hybrid image sensor with multimode shutters includes a plurality of pixel arrays each comprising: a charge storage device to receive charge from each of the light sensing elements of the pixel array; a first plurality of switches, each switch of the first plurality of switches connected between a respective pixel of the pixel array and the charge storage device; a second plurality of switches, the second plurality of switches comprising a rolling shutter selection switch and a global shutter selection switch, each of the rolling shutter selection switch and the global shutter selection switch connected in parallel to an output of the charge storage device; a plurality of pixel output lines, each pixel output line configured to output signals representative of pixel values corresponding to one or more pixel arrays coupled to the respective pixel output line.

## Description

### FIELD

The present application generally relates to image sensors and more particularly relates to hybrid image sensors with multimode shutters.

### BACKGROUND

A typical image sensor includes an array of pixel cells. Each pixel cell may include a photodiode to sense light by converting photons into charge (e.g., electrons or holes). The charge generated by the array of photodiodes can then be quantized by an analog-to-digital converter (ADC) into digital values to generate a digital image. The digital image may be exported from the sensor to another system (e.g., a viewing system for viewing the digital image, a processing system for interpreting the digital image, a compilation system for compiling a set of digital images, etc.).

### SUMMARY

According to an aspect, there is provided a sensor apparatus comprising:
a plurality of pixel arrays, each array of pixels comprising a plurality of pixels, each pixel comprising a light-sensing element configured to generate and store a charge in response to incoming light;
each pixel array comprising:
   a charge storage device configured to receive charge from each of the light-sensing elements of the pixel array;
   a first plurality of switches, each switch of the first plurality of switches connected between a respective pixel of the pixel array and the charge storage device;
   a second plurality of switches, the second plurality of switches comprising a high-resolution selection switch and a low-resolution selection switch, each of the high-resolution selection switch and the low-resolution selection switch connected in parallel to an output of the charge storage device;
a plurality of pixel output lines, each pixel output line configured to output signals representative of pixel values corresponding to one or more pixel arrays coupled to the respective pixel output line.

The sensor apparatus may further comprise:
a plurality of analog-to-digital converters, "ADCs", each ADC connected to an output of a respective pixel output line.

The sensor apparatus may further comprise, for each pixel array, a correlated double sampling, "CDS", component, the CDS component comprising:
a CDS reset value storage device, and
a CDS pixel value storage device; and
wherein:
   the second plurality of switches further comprises a CDS reset value switch connected to the output of the charge storage device in parallel to the high-resolution selection switch and the low-resolution selection switch,
   the CDS reset value switch connecting the charge storage device to a corresponding CDS reset value storage device,
   the low-resolution selection switch connecting the charge storage device to the CDS pixel value storage device,
   an output of the CDS reset value storage device connected to a respective pixel output line, and
   an output of the CDS pixel value storage device connected to the respective pixel output line; and
   wherein the sensor apparatus is configured to operate in a CDS mode and is configured to, for one or more pixel arrays:
      close and open a respective CDS reset value switch to sample a reset voltage by the CDS reset value storage device;
      close and open the switches of the first plurality of switches to transfer charges from the light-sensing elements to the respective charge storage device and close and open the respective resolution pixel value switch to sample a pixel voltage by the CDS pixel value storage device.

A subset of the plurality of pixel arrays may share a respective CDS component, and the subset of pixel arrays may be configured to be simultaneously connected to a respective CDS to provide voltage averaging for the subset of pixel arrays.

The sensor apparatus may be further configured to selectively close and open the high-resolution selection switch in sequence when each switch of the first plurality of switches is sequentially selectively closed to obtain a pixel value for each respective light-sensing element.

The sensor apparatus is further configured to:
selectively close the CDS reset switch while the first plurality of switches of a respective array of pixels are open to store a reset pixel value in the CDS reset value storage device; and
selectively close the CDS selection switch while the first plurality of switches of a respective array of pixels are closed to store a pixel value in the CDS pixel value storage device.

The sensor apparatus may further comprise, for each pixel array, a high-intensity pixel value storage device, and wherein
the second plurality of switches further comprises a high-intensity pixel value switch, and
the high-intensity pixel value switch connecting the charge storage device to a corresponding high-intensity pixel value storage device, and
wherein the sensor apparatus is configured to operate in a high-intensity CDS mode and is configured to, for one or more pixel arrays:
   close and open a respective CDS reset value switch to sample a reset voltage by the CDS reset value storage device;
   close and open a first switch of the respective first plurality of switches to transfer a first charge from a first light-sensing element to the respective charge storage device and close and open the respective high-intensity pixel value switch to sample a high-intensity voltage by the high-intensity pixel value storage device;
   close and open the remaining switches of the first plurality of switches to transfer charges from the remaining light-sensing elements to the respective charge storage device and close and open the respective resolution pixel value switch to sample a pixel voltage by the CDS pixel value storage device.

The sensor apparatus may be further configured to perform voltage binning for groups of pixel arrays.

The sensor apparatus may further comprise one or more correlated double sampling, "CDS", components, each CDS component comprising a comparator and an up-down counter, an input of the comparator connected to one or more low-resolution selection switches of one or more corresponding pixel arrays.

The sensor apparatus may be configured to operate in a high-resolution rolling-shutter mode or a low-resolution global-shutter mode. The sensor apparatus may be configured to:
sequentially selectively close each switch of the first plurality of switches for each array of pixels in the high-resolution rolling-shutter mode; and
simultaneously close each switch of the first plurality of switches for each array of pixels in the low-resolution global-shutter mode.

Each pixel array may comprise four light-sensing elements.

The sensor apparatus may further comprise one or more correlated double sampling, "CDS", components, each CDS component comprising a switched-capacitor integrator, a CDS reset value storage device, and a CDS pixel value storage device, wherein the CDS reset value storage device and the CDS pixel value storage device are selectively couplable to an output of the switched-capacitor integrator, and optionally wherein subsets of the plurality of pixel arrays are associated with a respective one of the CDS components.

Each pixel array may comprise four light-sensing elements arranged in a 2x2 grid.

According to another aspect, there is provided a sensor apparatus comprising: method comprising:
enabling, in an image sensor having at least a rolling-shutter mode and a global-shutter mode, the global shutter mode, the image sensor having a plurality of pixel arrays, each pixel array comprising a plurality of light-sensing elements and a charge storage device configured to receive charge from each of the light-sensing elements of the pixel array, the light-sensing elements selectively connectable to the charge storage device;
resetting the charge storage devices of the image sensor to establish a reset voltage;
transferring, for each pixel array, a reset voltage to a corresponding correlated double sampling, "CDS", component;
accumulating, during an integration period, charge within each of the light-sensing elements of the pixels arrays;
transferring, for each pixel array, accumulated charge from each light-sensing element to the corresponding charge storage device to store as a signal voltage;
transferring, for each pixel array, the signal voltage from the corresponding charge storage device to a corresponding CDS component;
outputting the reset voltage and the signal voltage from the corresponding CDS component.

The method may further comprise:
transferring, for each pixel array, accumulated charge from one light-sensing element to the corresponding charge storage device to store as a high-light signal voltage;
transferring, for each pixel array, the high-light signal voltage to the corresponding CDS component; and
outputting, for each pixel array, the high-light signal voltage from the corresponding CDS component.

The method may further comprise:
simultaneously transferring and averaging, for each CDS component, the signal voltages from all pixels arrays corresponding to the respective CDS component to the respective CDS component.

Each CDS component may comprise a switched-capacitor integrator, and the method may further comprise:
receiving and integrating, by each CDS component from the corresponding pixel arrays, the reset voltages;
storing, by each CDS component, the integrated reset voltage as the reset voltage;
receiving and integrating, by each CDS component from the corresponding pixel arrays, the signal voltages; and
storing, by each CDS component, the integrated reset voltage as the reset voltage.

The method may further comprise:
enabling, in the image sensor, a rolling shutter mode;
resetting, for each pixel array, the corresponding charge storage device;
accumulating, during a respective integration period, charge within each of the light-sensing elements of the pixels arrays;
for each light sensing-element in a respective pixel array, in sequence:
   transferring accumulated charge the respective light-sensing element to the corresponding charge storage device to store as a signal voltage; and
   transferring, for each pixel array, the signal voltage from the corresponding charge storage device to a column output line.

Each pixel array may comprise four light-sensing elements arranged in a 2x2 grid.

Various examples are described for hybrid image sensors with multimode shutters. In one example, an hybrid image sensor with multimode shutters includes a plurality of pixel arrays, each array of pixels comprising a plurality of pixels, each pixel comprising a light-sensing element configured to generate and store a charge in response to incoming light; each pixel array comprising: a charge storage device configured to receive charge from each of the light-sensing elements of the pixel array; a first plurality of switches, each switch of the first plurality of switches connected between a respective pixel of the pixel array and the charge storage device; a second plurality of switches, the second plurality of switches comprising a high-resolution selection switch and a low-resolution selection switch, each of the high-resolution selection switch and the low-resolution selection switch connected in parallel to an output of the charge storage device; a plurality of pixel output lines, each pixel output line configured to output signals representative of pixel values corresponding to one or more pixel arrays coupled to the respective pixel output line.

An example method for capturing an image using hybrid image sensors with multimode shutters includes enabling, in an image sensor having at least a rolling-shutter mode and a global-shutter mode, the global shutter mode, the image sensor having a plurality of pixel arrays, each pixel array comprising a plurality of light-sensing elements and a charge storage device configured to receive charge from each of the light-sensing elements of the pixel array, the light-sensing elements selectively connectable to the charge storage device; resetting the charge storage devices of the image sensor to establish a reset voltage; transferring, for each pixel array, a reset voltage to a corresponding correlated double sampling ("CDS") component; accumulating, during an integration period, charge within each of the light-sensing elements of the pixels arrays; transferring, for each pixel array, accumulated charge from each light-sensing element to the corresponding charge storage device to store as a signal voltage; transferring, for each pixel array, the signal voltage from the corresponding charge storage device to a corresponding CDS component; outputting the reset voltage and the signal voltage from the corresponding CDS component.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### BRIEF DESCRIPTION OF THE DRAWINGS

The accompanying drawings, which are incorporated into and constitute a part of this specification, illustrate one or more certain examples and, together with the description of the example, serve to explain the principles and implementations of the certain examples.
FIG. 1A and FIG. 1B are diagrams of an embodiment of a near-eye display.
FIG. 2 is an embodiment of a cross section of the near-eye display.
FIG. 3 illustrates an isometric view of an embodiment of a waveguide display with a single source assembly.
FIG. 4 illustrates a cross section of an embodiment of the waveguide display.
FIG. 5 is a block diagram of an embodiment of a system including the near-eye display.
FIG. 6 illustrates an example of an imaging system that includes a hybrid image sensor with multimode shutters.
FIG. 7 illustrates an example of pixel array for hybrid image sensors with multimode shutters.
FIGs. 8A-8B show an example pixel array and an example correlated double sampling component for hybrid image sensors with multimode shutters.
FIG. 9A shows a portion of an example hybrid image sensor with multimode shutters.
FIG. 9B shows a layout of an example hybrid image sensor with multimode shutters.
FIGs. 9C-9D show example timing diagrams for example hybrid image sensors with multimode shutters.
FIGs. 10A-10B show an example pixel array and an example correlated double sampling component for hybrid image sensors with multimode shutters.
FIG. 11 shows a portion of an example hybrid image sensor with multimode shutters.
FIGs. 12A-12B show an example pixel array and an example pixel array-level ADC for hybrid image sensors with multimode shutters.
FIG. 13 shows a portion of an example hybrid image sensor with multimode shutters.
FIGs. 14A-14B show an example pixel array and an example correlated double sampling component for hybrid image sensors with multimode shutters.
FIG. 15 shows a portion of an example hybrid image sensor with multimode shutters.
FIGs. 16-20 show example methods for image capture using hybrid image sensors with multimode shutters.

### DETAILED DESCRIPTION

Examples are described herein in the context of hybrid image sensors with multimode shutters. Those of ordinary skill in the art will realize that the following description is illustrative only and is not intended to be in any way limiting. Reference will now be made in detail to implementations of examples as illustrated in the accompanying drawings. The same reference indicators will be used throughout the drawings and the following description to refer to the same or like items.

In the interest of clarity, not all of the routine features of the examples described herein are shown and described. It will, of course, be appreciated that in the development of any such actual implementation, numerous implementation-specific decisions must be made in order to achieve the developer's specific goals, such as compliance with application- and business-related constraints, and that these specific goals will vary from one implementation to another and from one developer to another.

To capture an image, an image sensor uses an array of pixels, which include light-sensitive elements, such as photodiodes, to capture incoming photons and convert them to electric charge during an integration period. The electric charge can be stored in the light-sensitive element itself or it can be transferred to another charge storage device, such as a floating diffusion. At the end of the integration period, the accumulated electric charge is converted to a digital value, such as by first converting the charge to a voltage and then using an analog-to-digital converter ("ADC"), such as a comparator to compare a ramp voltage signal with the converted voltage. The digital value may then be used as the pixel value for the pixel.

The process of obtaining the various pixel values involves a "shutter" mechanism, which is the functional analog of the mechanical shutter in a conventional film camera. Shutters in an image sensor involve the choreographed accumulation of electric charge using light-sensing elements and the corresponding output of pixel values within the sensor to allow a single image to be generated from the pixel values.

Two common varieties of shutters in image sensors are rolling shutters and global shutters. An image sensor that employs a rolling shutter captures pixel values a row at a time, such as by arranging ADCs to receive pixel values for a particular column of pixels in the pixel array, referred to as a column ADC. Pixels in a row may then be integrated and then read-out by closing a switch to connect them to a corresponding column readout line, which connects the pixel to the column ADC. The column ADCs generate pixel values and store them in memory, before the next row of pixels is integrated and readout using the same process. Thus, the image capture process proceeds over a period of time needed to successively integrate and readout pixel values row-by-row. In contrast, an image sensor with a global shutter simultaneously integrates all pixels, which can then be processed by an ADC to generate an image.

The different types of shutters have different advantages and disadvantages, and selecting the appropriate shutter mechanism for an image sensor leads to trade-offs. For example, a rolling shutter can introduce distortions into a captured image because each successive row of pixels will be captured slightly offset in time from the preceding row's. Thus, for an image sensor with a large number of rows, the accumulated delay across all of the rows can affect the appearance moving objects within the image as the lower portion of the object will have moved farther by the time it is captured than the upper portion of the object, distorting its appearance. And while a global shutter can be used to avoid such distortions, they tend to be larger and more expensive because many more circuit components must be integrated into the image sensor. However, oftentimes, in virtual reality ("VR"), augmented reality ("AR"), or mixed reality ("MR") applications, both types of sensors may be desirable.

In VR/AR/MR applications, a global shutter may be desirable to provide undistorted images to computer vision ("CV") functionality, such as object recognition and tracking, simultaneous localization and mapping ("SLAM") functionality, etc., to allow for high-quality VR/AR/MR experiences. Image distortion introduced by a rolling shutter may impact the ability of CV applications to provide accurate or reliable outputs. However, rolling shutter image sensors may be desirable for providing video to the user since the user is less affected by such image distortion and because of the reduced cost for such image sensors.

However, employing multiple image sensors to provide CV and user video can increase the overall cost and complexity of an VR/AR/MR device: multiple global shutter sensors may be used to capture images for different fields of view ("FOV") for CV processing, while multiple rolling shutter image sensors may be provided to provide an increased FOV or stereoscopic imaging for the user. Further, because CV functionality will usually be involved in affecting the user perception of the VR/AR/MR environment, using multiple image sensors for CV and for user video means that the image sensors providing CV images will be physically offset from the image sensors providing video to the user. This offset can impact the appearance of any virtual objects or effects generated in the user's display based on CV functionality. Alternatively, additional computational complexity may be introduced to compensate for the offsets between the various image sensors.

To help address these and other problems with image sensors, an example hybrid image sensor with multimode shutters is configured with both global and local shutter functionality. The example image sensor includes a pixel array, e.g., an M x N array of pixels, where each pixel includes a light-sensitive element and the pixels are arranged into 2 x 2 arrays of pixels, though any size arrays may be used. Each array of pixels includes a common charge storage device that is connected to the input of a source follower. In addition, each array has a corresponding correlated double sampling (CDS) component that includes two charge storage devices, one to store a reset voltage for the pixel array, or multiple pixel arrays arranged to form a pixel cluster and share a common CDS component, and the other to store the signal voltage for the pixel array after integration. The two charge storage devices are configured as inputs to a corresponding source follower, both of whose outputs are connected to a column line corresponding to the pixel array.

The pixel array's source follower is used to output a voltage based on the charge stored in the pixel array's charge storage device. The output of the source follower is presented to three parallel switches. A first switch, the rolling-shutter select ("RSSEL") switch, connects the source follower output to the column line corresponding to the pixel array. The second switch, the global shutter reset ("GSR") switch, connects the source follower output to the reset charge storage device in the CDS component. The third switch, the global shutter signal ("GSS") switch, connects the source follower output to the pixel value charge storage device in the CDS component.

In operation, the image sensor is configured to either the rolling shutter or global shutter mode for a particular image. In the rolling shutter configuration, each photodiode in a pixel array is sequentially connected to the pixel array's charge storage device and the RSSEL switch is used to read out the voltages to a column ADC. Thus, for each row of a pixel array, two photodiodes are sequentially read, and the column ADCs sequentially convert the voltages to pixel values. Each row of pixel arrays is then integrated and readout in succession. This provides a high-resolution image, where each photodiode provides a discrete pixel value, but the outputted image may include rolling-shutter artifacts.

In the global shutter mode, all four photodiodes are connected to the charge storage device simultaneously, leading to a single voltage for each pixel array. In CDS operation, a reset value is first captured at the CDS component by resetting the charge storage device and asserting the GSR line. The four photodiodes are then connected to the charge storage device and a composite voltage is generated. The GSS line is then asserted, transferring the charge to CDS component. Because all pixels integrate at the same time, a global shutter is achieved. Readout of the reset and pixel values stored in the CDS components may be performed row-by-row using the same column ADCs as discussed above. This mode provides a low-resolution image, where each pixel array provides a combined pixel value for all photodiodes in the cluster, but the outputted image lacks the rolling-shutter artifacts. Thus, the same image sensor can capture images suitable both for presentation to a user and for various CV processes that may be used in the system. And while this example connects a single pixel array to a CDS component, some examples discussed below may associate multiple pixel arrays to a single CDS component.

This illustrative example is given to introduce the reader to the general subject matter discussed herein and the disclosure is not limited to this example. The following sections describe various additional non-limiting examples and examples of hybrid image sensors with multimode shutters.

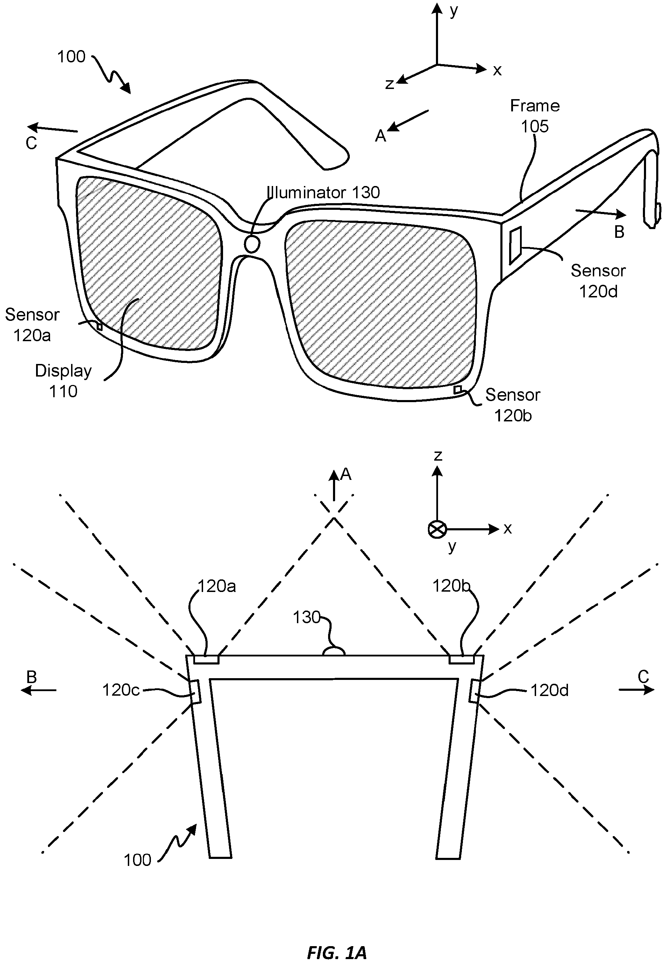

FIG. 1A is a diagram of an embodiment of a near-eye display 100. Near-eye display 100 presents media to a user. Examples of media presented by near-eye display 100 include one or more images, video, and/or audio. In some embodiments, audio is presented via an external device (e.g., speakers and/or headphones) that receives audio information from the near-eye display 100, a console, or both, and presents audio data based on the audio information. Near-eye display 100 is generally configured to operate as a virtual reality (VR) display. In some embodiments, near-eye display 100 is modified to operate as an augmented reality (AR) display and/or a mixed reality (MR) display.

Near-eye display 100 includes a frame 105 and a display 110. Frame 105 is coupled to one or more optical elements. Display 110 is configured for the user to see content presented by near-eye display 100. In some embodiments, display 110 comprises a waveguide display assembly for directing light from one or more images to an eye of the user.

Near-eye display 100 further includes image sensors 120a, 120b, 120c, and 120d. Each of image sensors 120a, 120b, 120c, and 120d may include a pixel array configured to generate image data representing different fields of views along different directions. For example, sensors 120a and 120b may be configured to provide image data representing two fields of view towards a direction A along the Z axis, whereas sensor 120c may be configured to provide image data representing a field of view towards a direction B along the X axis, and sensor 120d may be configured to provide image data representing a field of view towards a direction C along the X axis.

In some embodiments, sensors 120a-120d can be configured as input devices to control or influence the display content of the near-eye display 100 to provide an interactive VR/AR/MR experience to a user who wears near-eye display 100. For example, sensors 120a-120d can generate physical image data of a physical environment in which the user is located. The physical image data can be provided to a location tracking system to track a location and/or a path of movement of the user in the physical environment. A system can then update the image data provided to display 110 based on, for example, the location and orientation of the user, to provide the interactive experience. In some embodiments, the location tracking system may operate a SLAM algorithm to track a set of objects in the physical environment and within a view of field of the user as the user moves within the physical environment. The location tracking system can construct and update a map of the physical environment based on the set of objects, and track the location of the user within the map. By providing image data corresponding to multiple fields of views, sensors 120a-120d can provide the location tracking system a more holistic view of the physical environment, which can lead to more objects to be included in the construction and updating of the map. With such an arrangement, the accuracy and robustness of tracking a location of the user within the physical environment can be improved.

In some embodiments, near-eye display 100 may further include one or more active illuminators 130 to project light into the physical environment. The light projected can be associated with different frequency spectrums (e.g., visible light, infra-red light, ultra-violet light), and can serve various purposes. For example, illuminator 130 may project light in a dark environment (or in an environment with low intensity of infra-red light, ultra-violet light, etc.) to assist sensors 120a-120d in capturing images of different objects within the dark environment to, for example, enable location tracking of the user. Illuminator 130 may project certain markers onto the objects within the environment, to assist the location tracking system in identifying the objects for map construction/updating.

In some embodiments, illuminator 130 may also enable stereoscopic imaging. For example, one or more of sensors 120a or 120b can include both a first pixel array for visible light sensing and a second pixel array for infra-red (IR) light sensing. The first pixel array can be overlaid with a color filter (e.g., a Bayer filter), with each pixel of the first pixel array being configured to measure intensity of light associated with a particular color (e.g., one of red, green or blue colors). The second pixel array (for IR light sensing) can also be overlaid with a filter that allows only IR light through, with each pixel of the second pixel array being configured to measure intensity of IR lights. The pixel arrays can generate an RGB image and an IR image of an object, with each pixel of the IR image being mapped to each pixel of the RGB image. Illuminator 130 may project a set of IR markers on the object, the images of which can be captured by the IR pixel array. Based on a distribution of the IR markers of the object as shown in the image, the system can estimate a distance of different parts of the object from the IR pixel array, and generate a stereoscopic image of the object based on the distances. Based on the stereoscopic image of the object, the system can determine, for example, a relative position of the object with respect to the user, and can update the image data provided to display 100 based on the relative position information to provide the interactive experience.

As discussed above, near-eye display 100 may be operated in environments associated with a very wide range of light intensities. For example, near-eye display 100 may be operated in an indoor environment or in an outdoor environment, and/or at different times of the day. Near-eye display 100 may also operate with or without active illuminator 130 being turned on. As a result, image sensors 120a-120d may need to have a wide dynamic range to be able to operate properly (e.g., to generate an output that correlates with the intensity of incident light) across a very wide range of light intensities associated with different operating environments for near-eye display 100.

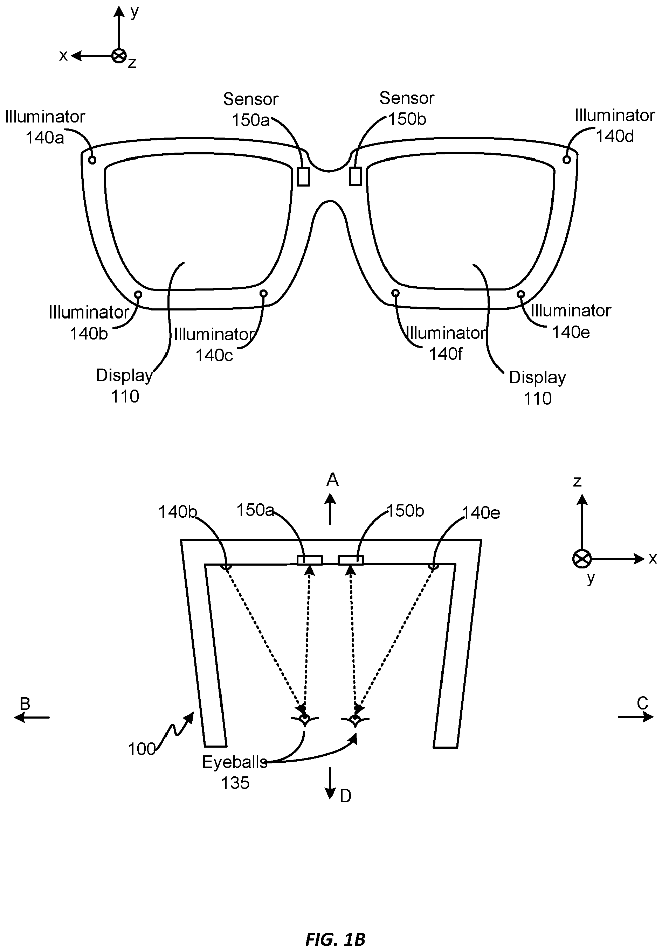

FIG. 1B is a diagram of another embodiment of near-eye display 100. FIG. 1B illustrates a side of near-eye display 100 that faces the eyeball(s) 135 of the user who wears near-eye display 100. As shown in FIG. 1B, near-eye display 100 may further include a plurality of illuminators 140a, 140b, 140c, 140d, 140e, and 140f. Near-eye display 100 further includes a plurality of image sensors 150a and 150b. Illuminators 140a, 140b, and 140c may emit lights of certain frequency range (e.g., NIR) towards direction D (which is opposite to direction A of FIG. 1A). The emitted light may be associated with a certain pattern, and can be reflected by the left eyeball of the user. Sensor 150a may include a pixel array to receive the reflected light and generate an image of the reflected pattern. Similarly, illuminators 140d, 140e, and 140f may emit NIR lights carrying the pattern. The NIR lights can be reflected by the right eyeball of the user, and may be received by sensor 150b. Sensor 150b may also include a pixel array to generate an image of the reflected pattern. Based on the images of the reflected pattern from sensors 150a and 150b, the system can determine a gaze point of the user, and update the image data provided to display 100 based on the determined gaze point to provide an interactive experience to the user.

As discussed above, to avoid damaging the eyeballs of the user, illuminators 140a, 140b, 140c, 140d, 140e, and 140f are typically configured to output lights of very low intensities. In a case where image sensors 150a and 150b comprise the same sensor devices as image sensors 120a-120d of FIG. 1A, the image sensors 120a-120d may need to be able to generate an output that correlates with the intensity of incident light when the intensity of the incident light is very low, which may further increase the dynamic range requirement of the image sensors.

Moreover, the image sensors 120a-120d may need to be able to generate an output at a high speed to track the movements of the eyeballs. For example, a user's eyeball can perform a very rapid movement (e.g., a saccade movement) in which there can be a quick jump from one eyeball position to another. To track the rapid movement of the user's eyeball, image sensors 120a-120d need to generate images of the eyeball at high speed. For example, the rate at which the image sensors generate an image frame (the frame rate) needs to at least match the speed of movement of the eyeball. The high frame rate requires short total exposure time for all of the pixel cells involved in generating the image frame, as well as high speed for converting the sensor outputs into digital values for image generation. Moreover, as discussed above, the image sensors also need to be able to operate at an environment with low light intensity.

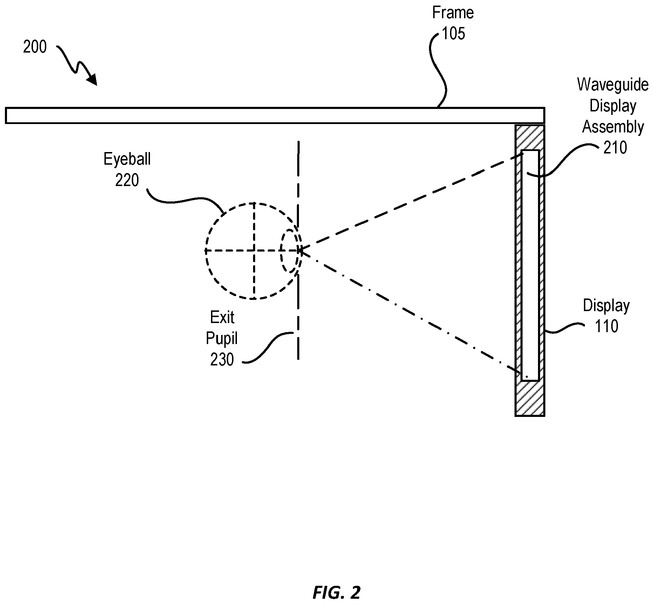

FIG. 2 is an embodiment of a cross section 200 of near-eye display 100 illustrated in FIG. 1. Display 110 includes at least one waveguide display assembly 210. An exit pupil 230 is a location where a single eyeball 220 of the user is positioned in an eyebox region when the user wears the near-eye display 100. For purposes of illustration, FIG. 2 shows the cross section 200 associated eyeball 220 and a single waveguide display assembly 210, but a second waveguide display is used for a second eye of a user.

Waveguide display assembly 210 is configured to direct image light to an eyebox located at exit pupil 230 and to eyeball 220. Waveguide display assembly 210 may be composed of one or more materials (e.g., plastic, glass) with one or more refractive indices. In some embodiments, near-eye display 100 includes one or more optical elements between waveguide display assembly 210 and eyeball 220.

In some embodiments, waveguide display assembly 210 includes a stack of one or more waveguide displays including, but not restricted to, a stacked waveguide display, a varifocal waveguide display, etc. The stacked waveguide display is a polychromatic display (e.g., a red-green-blue (RGB) display) created by stacking waveguide displays whose respective monochromatic sources are of different colors. The stacked waveguide display is also a polychromatic display that can be projected on multiple planes (e.g., multi-planar colored display). In some configurations, the stacked waveguide display is a monochromatic display that can be projected on multiple planes (e.g., multi-planar monochromatic display). The varifocal waveguide display is a display that can adjust a focal position of image light emitted from the waveguide display. In alternate embodiments, waveguide display assembly 210 may include the stacked waveguide display and the varifocal waveguide display.

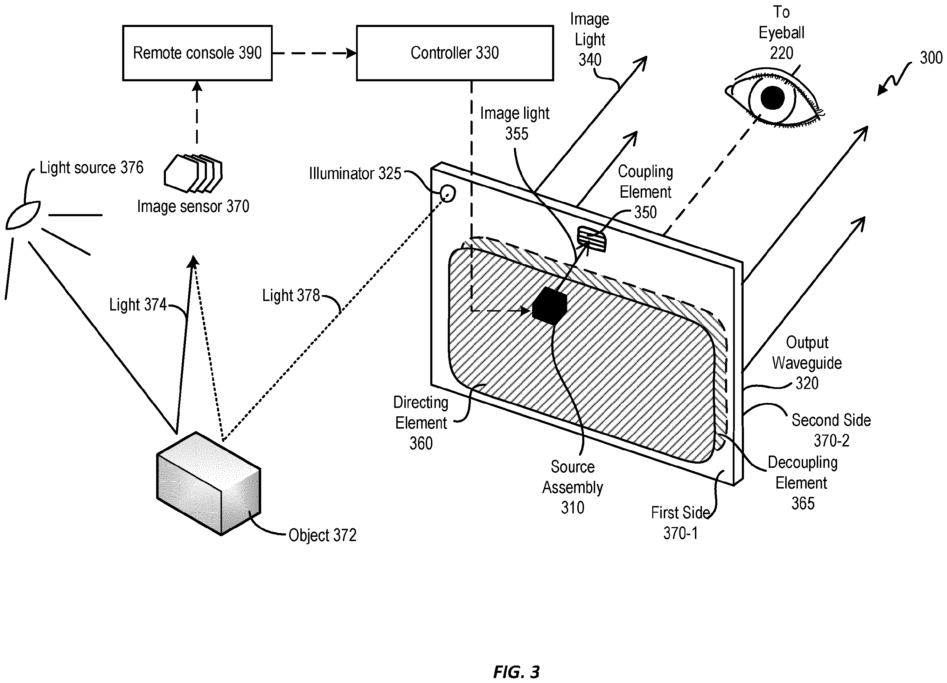

FIG. 3 illustrates an isometric view of an embodiment of a waveguide display 300. In some embodiments, waveguide display 300 is a component (e.g., waveguide display assembly 210) of near-eye display 100. In some embodiments, waveguide display 300 is part of some other near-eye display or other system that directs image light to a particular location.

Waveguide display 300 includes a source assembly 310, an output waveguide 320, and a controller 330. For purposes of illustration, FIG. 3 shows the waveguide display 300 associated with a single eyeball 220, but in some embodiments, another waveguide display separate, or partially separate, from the waveguide display 300 provides image light to another eye of the user.

Source assembly 310 generates and outputs image light 355 to a coupling element 350 located on a first side 370-1 of output waveguide 320. Output waveguide 320 is an optical waveguide that outputs expanded image light 340 to an eyeball 220 of a user. Output waveguide 320 receives image light 355 at one or more coupling elements 350 located on the first side 370-1 and guides received input image light 355 to a directing element 360. In some embodiments, coupling element 350 couples the image light 355 from source assembly 310 into output waveguide 320. Coupling element 350 may be, e.g., a diffraction grating, a holographic grating, one or more cascaded reflectors, one or more prismatic surface elements, and/or an array of holographic reflectors.

Directing element 360 redirects the received input image light 355 to decoupling element 365 such that the received input image light 355 is decoupled out of output waveguide 320 via decoupling element 365. Directing element 360 is part of, or affixed to, first side 370-1 of output waveguide 320. Decoupling element 365 is part of, or affixed to, second side 370-2 of output waveguide 320, such that directing element 360 is opposed to the decoupling element 365. Directing element 360 and/or decoupling element 365 may be, e.g., a diffraction grating, a holographic grating, one or more cascaded reflectors, one or more prismatic surface elements, and/or an array of holographic reflectors.

Second side 370-2 represents a plane along an x-dimension and a y-dimension. Output waveguide 320 may be composed of one or more materials that facilitate total internal reflection of image light 355. Output waveguide 320 may be composed of e.g., silicon, plastic, glass, and/or polymers. Output waveguide 320 has a relatively small form factor. For example, output waveguide 320 may be approximately 50 mm wide along x-dimension, 30 mm long along y-dimension and 0.5-1 mm thick along a z-dimension.

Controller 330 controls scanning operations of source assembly 310. The controller 330 determines scanning instructions for the source assembly 310. In some embodiments, the output waveguide 320 outputs expanded image light 340 to the user's eyeball 220 with a large field of view (FOV). For example, the expanded image light 340 is provided to the user's eyeball 220 with a diagonal FOV (in x and y) of 60 degrees and/or greater and/or 150 degrees and/or less. The output waveguide 320 is configured to provide an eyebox with a length of 20 mm or greater and/or equal to or less than 50 mm; and/or a width of 10 mm or greater and/or equal to or less than 50 mm.

Moreover, controller 330 also controls image light 355 generated by source assembly 310, based on image data provided by image sensor 370. Image sensor 370 may be located on first side 370-1 and may include, for example, image sensors 120a-120d of FIG. 1A. Image sensors 120a-120d can be operated to perform 2D sensing and 3D sensing of, for example, an object 372 in front of the user (e.g., facing first side 370-1). For 2D sensing, each pixel cell of image sensors 120a-120d can be operated to generate pixel data representing an intensity of light 374 generated by a light source 376 and reflected off object 372. For 3D sensing, each pixel cell of image sensors 120a-120d can be operated to generate pixel data representing a time-of-flight measurement for light 378 generated by illuminator 325. For example, each pixel cell of image sensors 120a-120d can determine a first time when illuminator 325 is enabled to project light 378 and a second time when the pixel cell detects light 378 reflected off object 372. The difference between the first time and the second time can indicate the time-of-flight of light 378 between image sensors 120a-120d and object 372, and the time-of-flight information can be used to determine a distance between image sensors 120a-120d and object 372. Image sensors 120a-120d can be operated to perform 2D and 3D sensing at different times, and provide the 2D and 3D image data to a remote console 390 that may be (or may not be) located within waveguide display 300. The remote console may combine the 2D and 3D images to, for example, generate a 3D model of the environment in which the user is located, to track a location and/or orientation of the user, etc. The remote console may determine the content of the images to be displayed to the user based on the information derived from the 2D and 3D images. The remote console can transmit instructions to controller 330 related to the determined content. Based on the instructions, controller 330 can control the generation and outputting of image light 355 by source assembly 310, to provide an interactive experience to the user.

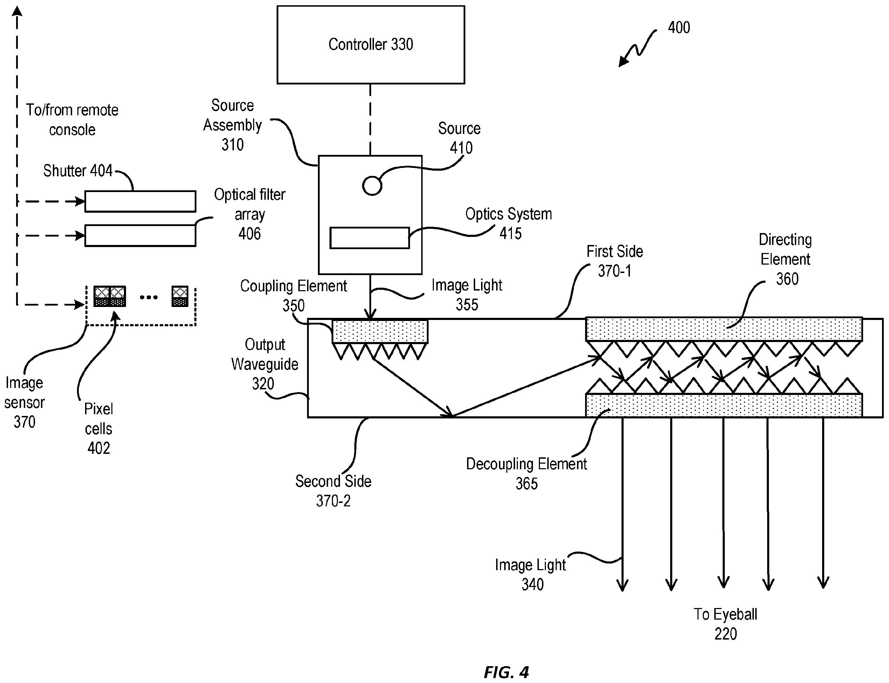

FIG. 4 illustrates an embodiment of a cross section 400 of the waveguide display 300. The cross section 400 includes source assembly 310, output waveguide 320, and image sensor 370. In the example of FIG. 4, image sensor 370 may include a set of pixel cells 402 located on first side 370-1 to generate an image of the physical environment in front of the user. In some embodiments, there can be a mechanical shutter 404 and an optical filter array 406 interposed between the set of pixel cells 402 and the physical environment. Mechanical shutter 404 can control the exposure of the set of pixel cells 402. In some embodiments, the mechanical shutter 404 can be replaced by an electronic shutter gate, as to be discussed below. Optical filter array 406 can control an optical wavelength range of light the set of pixel cells 402 is exposed to, as to be discussed below. Each of pixel cells 402 may correspond to one pixel of the image. Although not shown in FIG. 4, it is understood that each of pixel cells 402 may also be overlaid with a filter to control the optical wavelength range of the light to be sensed by the pixel cells.

After receiving instructions from the remote console, mechanical shutter 404 can open and expose the set of pixel cells 402 in an exposure period. During the exposure period, image sensor 370 can obtain samples of lights incident on the set of pixel cells 402, and generate image data based on an intensity distribution of the incident light samples detected by the set of pixel cells 402. Image sensor 370 can then provide the image data to the remote console, which determines the display content, and provide the display content information to controller 330. Controller 330 can then determine image light 355 based on the display content information.

Source assembly 310 generates image light 355 in accordance with instructions from the controller 330. Source assembly 310 includes a source 410 and an optics system 415. Source 410 is a light source that generates coherent or partially coherent light. Source 410 may be, e.g., a laser diode, a vertical cavity surface emitting laser, and/or a light emitting diode.

Optics system 415 includes one or more optical components that condition the light from source 410. Conditioning light from source 410 may include, e.g., expanding, collimating, and/or adjusting orientation in accordance with instructions from controller 330. The one or more optical components may include one or more lenses, liquid lenses, mirrors, apertures, and/or gratings. In some embodiments, optics system 415 includes a liquid lens with a plurality of electrodes that allows scanning of a beam of light with a threshold value of scanning angle to shift the beam of light to a region outside the liquid lens. Light emitted from the optics system 415 (and also source assembly 310) is referred to as image light 355.

Output waveguide 320 receives image light 355. Coupling element 350 couples image light 355 from source assembly 310 into output waveguide 320. In embodiments where coupling element 350 is a diffraction grating, a pitch of the diffraction grating is chosen such that total internal reflection occurs in output waveguide 320, and image light 355 propagates internally in output waveguide 320 (e.g., by total internal reflection), toward decoupling element 365.

Directing element 360 redirects image light 355 toward decoupling element 365 for decoupling from output waveguide 320. In embodiments where directing element 360 is a diffraction grating, the pitch of the diffraction grating is chosen to cause incident image light 355 to exit output waveguide 320 at angle(s) of inclination relative to a surface of decoupling element 365.

In some embodiments, directing element 360 and/or decoupling element 365 are structurally similar. Expanded image light 340 exiting output waveguide 320 is expanded along one or more dimensions (e.g., may be elongated along x-dimension). In some embodiments, waveguide display 300 includes a plurality of source assemblies 310 and a plurality of output waveguides 320. Each of source assemblies 310 emits a monochromatic image light of a specific band of wavelength corresponding to a primary color (e.g., red, green, or blue). Each of output waveguides 320 may be stacked together with a distance of separation to output an expanded image light 340 that is multi-colored.

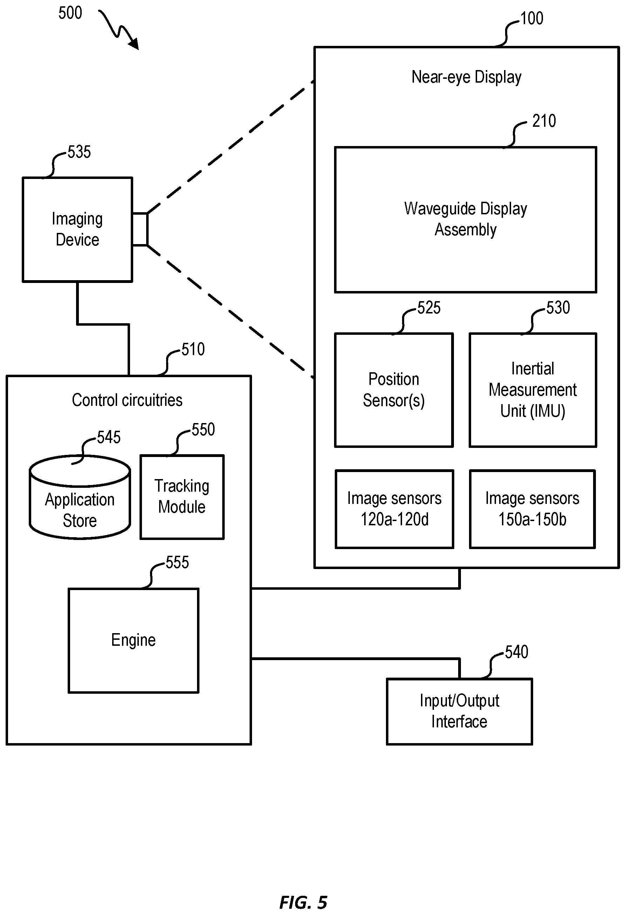

FIG. 5 is a block diagram of an embodiment of a system 500 including the near-eye display 100. The system 500 comprises near-eye display 100, an imaging device 535, an input/output interface 540, and image sensors 120a-120d and 150a-150b that are each coupled to control circuitries 510. System 500 can be configured as a head-mounted device, a mobile device, a wearable device, etc.

Near-eye display 100 is a display that presents media to a user. Examples of media presented by the near-eye display 100 include one or more images, video, and/or audio. In some embodiments, audio is presented via an external device (e.g., speakers and/or headphones) that receives audio information from near-eye display 100 and/or control circuitries 510 and presents audio data based on the audio information to a user. In some embodiments, near-eye display 100 may also act as an AR eyewear glass. In some embodiments, near-eye display 100 augments views of a physical, real-world environment, with computer-generated elements (e.g., images, video, sound).

Near-eye display 100 includes waveguide display assembly 210, one or more position sensors 525, and/or an inertial measurement unit (IMU) 530. Waveguide display assembly 210 includes source assembly 310, output waveguide 320, and controller 330.

IMU 530 is an electronic device that generates fast calibration data indicating an estimated position of near-eye display 100 relative to an initial position of near-eye display 100 based on measurement signals received from one or more of position sensors 525.

Imaging device 535 may generate image data for various applications. For example, imaging device 535 may generate image data to provide slow calibration data in accordance with calibration parameters received from control circuitries 510. Imaging device 535 may include, for example, image sensors 120a-120d of FIG. 1A for generating image data of a physical environment in which the user is located for performing location tracking of the user. Imaging device 535 may further include, for example, image sensors 150a-150b of FIG. 1B for generating image data for determining a gaze point of the user to identify an object of interest of the user.

The input/output interface 540 is a device that allows a user to send action requests to the control circuitries 510. An action request is a request to perform a particular action. For example, an action request may be to start or end an application or to perform a particular action within the application.

Control circuitries 510 provide media to near-eye display 100 for presentation to the user in accordance with information received from one or more of: imaging device 535, near-eye display 100, and input/output interface 540. In some examples, control circuitries 510 can be housed within system 500 configured as a head-mounted device. In some examples, control circuitries 510 can be a standalone console device communicatively coupled with other components of system 500. In the example shown in FIG. 5, control circuitries 510 include an application store 545, a tracking module 550, and an engine 555.

The application store 545 stores one or more applications for execution by the control circuitries 510. An application is a group of instructions that, when executed by a processor, generates content for presentation to the user. Examples of applications include: gaming applications, conferencing applications, video playback applications, or other suitable applications.

Tracking module 550 calibrates system 500 using one or more calibration parameters and may adjust one or more calibration parameters to reduce error in determination of the position of the near-eye display 100.

Tracking module 550 tracks movements of near-eye display 100 using slow calibration information from the imaging device 535. Tracking module 550 also determines positions of a reference point of near-eye display 100 using position information from the fast calibration information.

Engine 555 executes applications within system 500 and receives position information, acceleration information, velocity information, and/or predicted future positions of near-eye display 100 from tracking module 550. In some embodiments, information received by engine 555 may be used for producing a signal (e.g., display instructions) to waveguide display assembly 210 that determines a type of content presented to the user. For example, to provide an interactive experience, engine 555 may determine the content to be presented to the user based on a location of the user (e.g., provided by tracking module 550), or a gaze point of the user (e.g., based on image data provided by imaging device 535), a distance between an object and user (e.g., based on image data provided by imaging device 535).

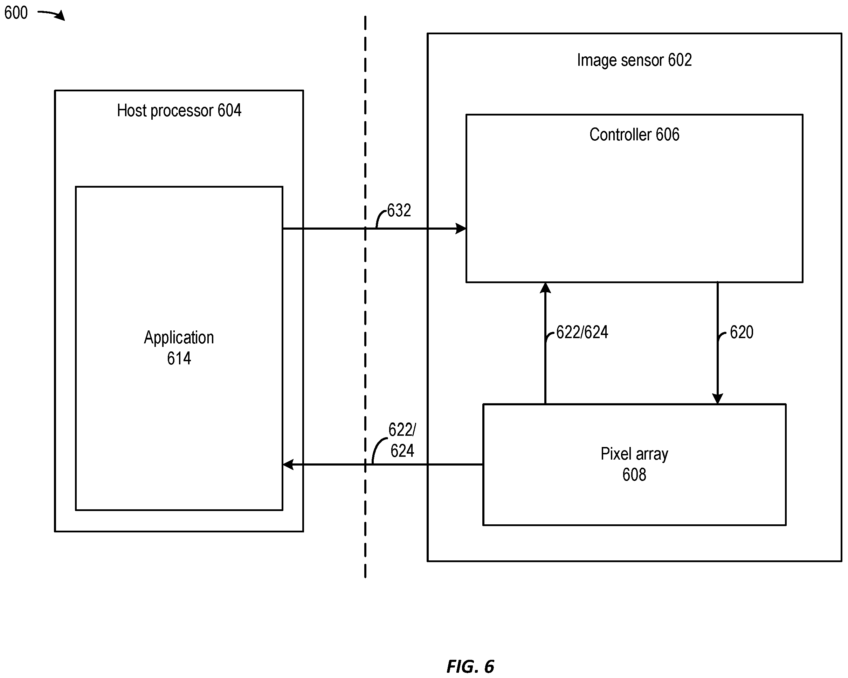

FIG. 6 illustrates an example of an imaging system 600 that can perform image sub-sampling with a color grid array. As shown in FIG. 6, imaging system 600 includes an image sensor 602 and a host processor 604. Image sensor 602 includes a controller 606 and a pixel array 608. In some examples, controller 606 can be implemented as an application specific integrated circuit (ASIC), a field programmable gate array (FPGA), or a hardware processor that executes instructions to enable image sub-sampling with a color grid array. In addition, host processor 604 includes a general purpose central processing unit (CPU) which can execute an application 614.

Each pixel of pixel array 608 receives incoming light and converts it into an electric charge, which is stored as a voltage on a charge storage device. In addition, each pixel in the pixel array 608 is individually addressable using row and column select lines, which cause corresponding row- and column-select switches to close, thereby providing a voltage to ADC circuitry from the pixel where it is converted into a pixel value which can be read out, such as to controller 606 or application 614.

In the pixel array 608, pixels are grouped together to form super-pixels, which provide common ADC circuitry for the grouped pixels. For example, a super-pixel may include four pixels arranged in a 2x2 grid. Thus, a 128x128 pixel array using such a configuration would create a 64x64 super-pixel array. To provide different color or frequency sensing, the different pixels within a super-pixel may be configured with different filters, such as to capture different visible color bands (e.g., red, green, blue, yellow, white), different spectral bands (e.g., near-infrared ("IR"), monochrome, ultraviolet ("UV"), IR cut, IR band pass), or similar. Thus, by enabling or disabling different pixels, each super-pixel can provide any subset of such information. Further, by only sampling certain super pixels, sparse image sensing can be employed to only capture image information corresponding to a subset of pixels in the pixel array 608.

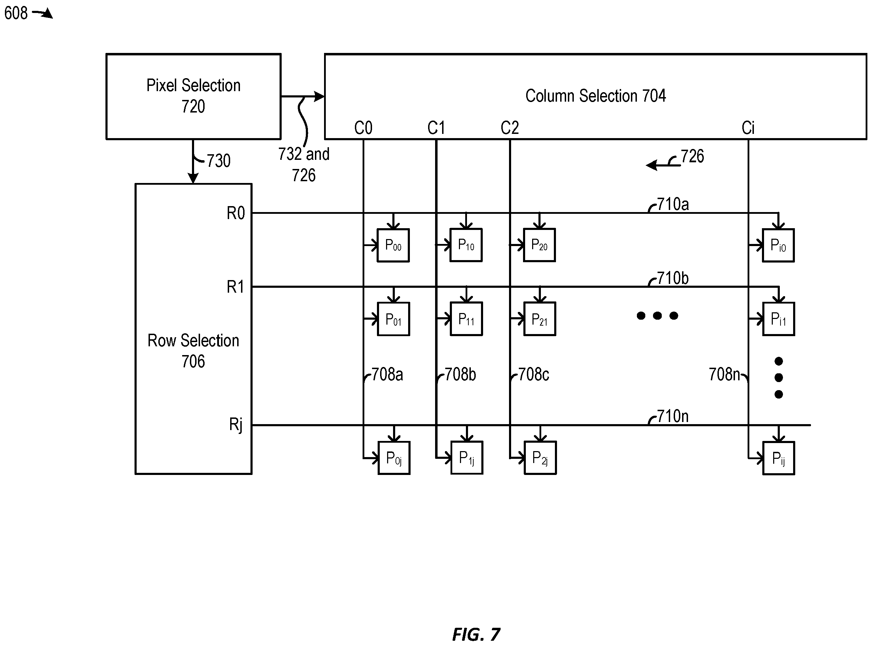

FIG. 7 illustrates an example of pixel array 608. As shown in FIG. 7, pixel cell array 608 may include a column controller 704, a row controller 706, and a pixel selection controller 720. Column selection controller 704 is connected with column-select lines 708 (e.g., 708a, 708b, 708c, ... 708n), whereas row selection controller 706 is connected with row-select lines 710 (e.g., 710a, 710b, ... 708n). Each box labelled P00, P01, P0j, ..., Pij represents a pixel. Each pixel is connected to one of column-select lines 708, one of row-select lines 710 and an output data bus to output pixel data (not shown in FIG. 7). Each pixel is individually addressable by column-enable signals 730 on column-select lines 708 provided by column selection controller 704, and row-enable signals 732 on row-select lines 710 provided by row selection controller 706. Column-enable signals 730 and row-enable signals 732 can be generated based on information received from controller 606 or host processor 604.

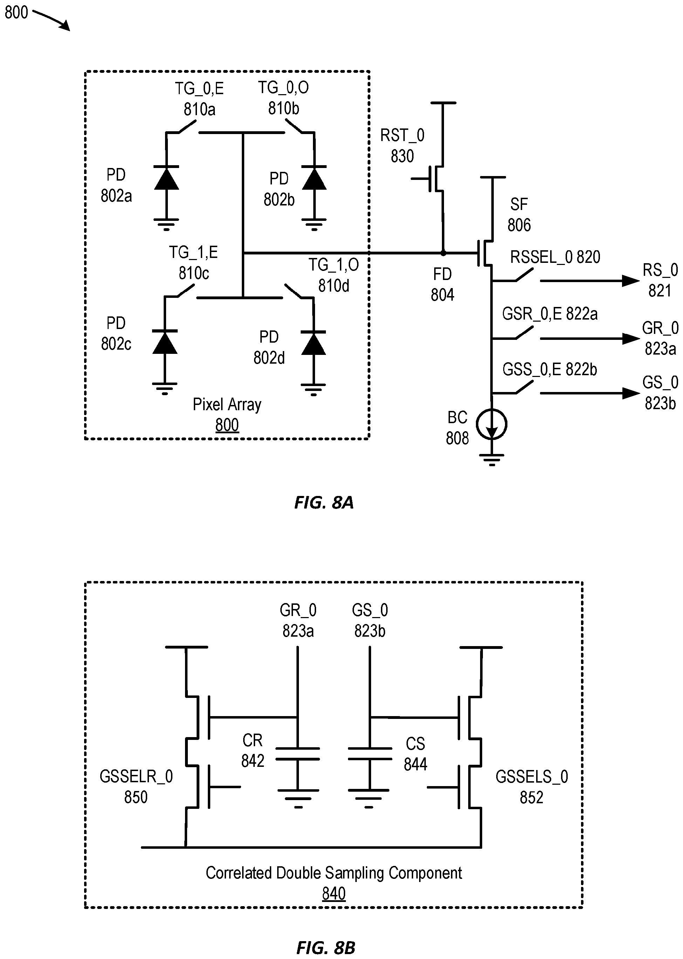

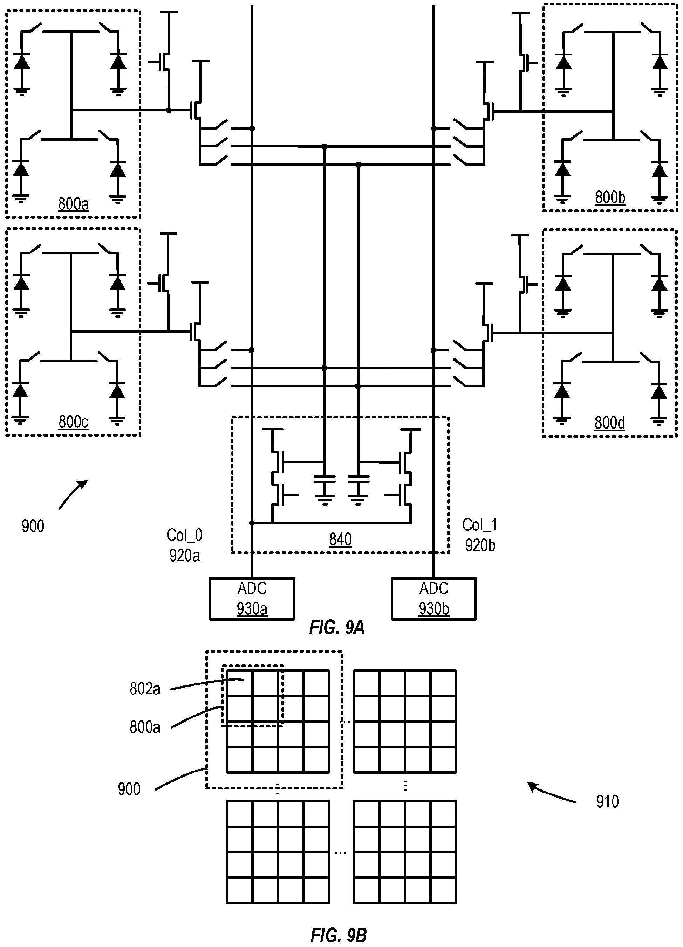

FIGs. 8A-8B show an example pixel array 800 and an example CDS component 840 suitable for use with example hybrid image sensors with multimode shutters. Referring to FIG. 8A, the pixel array 800 includes four photodiodes 802a-d, each of which is connected to a charge storage device, such as a floating diffusion ("FD") region 804. Each of the photodiodes 802a-d can be selectively coupled to the FD region 804 by a corresponding transfer gate switch 810a-d. The FD region 804 provides an input voltage to the source follower ("SF") 806, whose output is connected to three parallel output lines that can be selectively activated by a corresponding switch 820, 822a-b based on a rolling-shutter select (RSSEL_x) signal, a global-shutter reset (GSR_x,y) signal, or a global-shutter switch (GSS_x,y) signal. The "x" represents a particular row in the sensor array, while the "y" represents the "odd" or "even" column of pixel array in a cluster of pixel arrays. As will be discussed in more detail with respect to FIG. 9A, multiple pixel arrays 800 may share a common CDS component 840. Thus, the "y" value designating "odd" or "even" indicates which "column" of pixel arrays for a particular CDS cluster are activated, while the "x" value designates "odd" or "even" with respect to the row for a particular CDS cluster to be activated. And while "y" only has two different values in this example, in some examples, the "y" value may have more than two options.

An image sensor will typically include multiple pixel arrays 800 arranged in a two-dimensional grid to provide the desired image sensor resolution. The pixel arrays 800 can be operated in either rolling shutter or global shutter modes by selectively activating different switches within the pixel array. In addition, the resolution of the pixel array 800 can be adjusted between full resolution and low resolution. Thus, the pixel array 800 provides flexibility for the image sensor to capture the desired resolution and using the application-appropriate shutter.

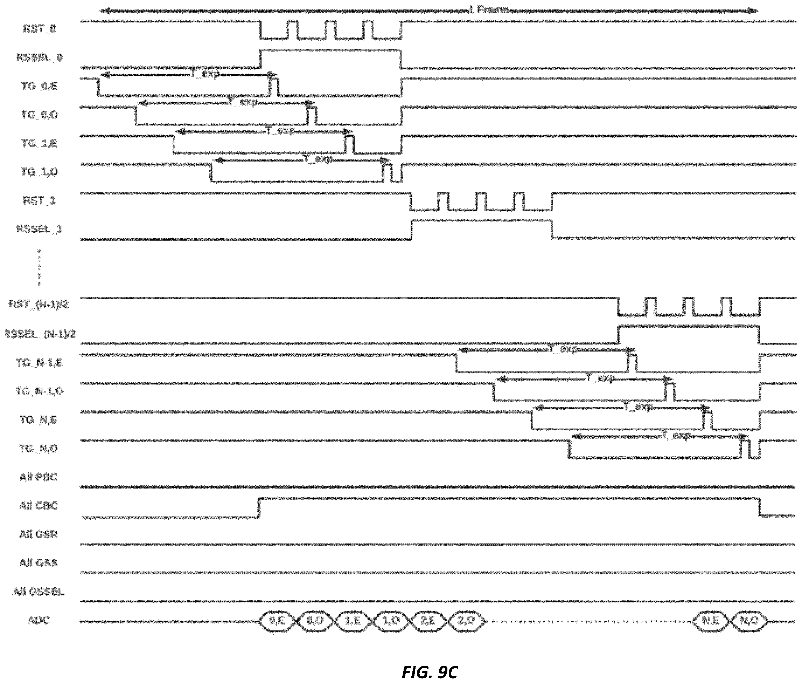

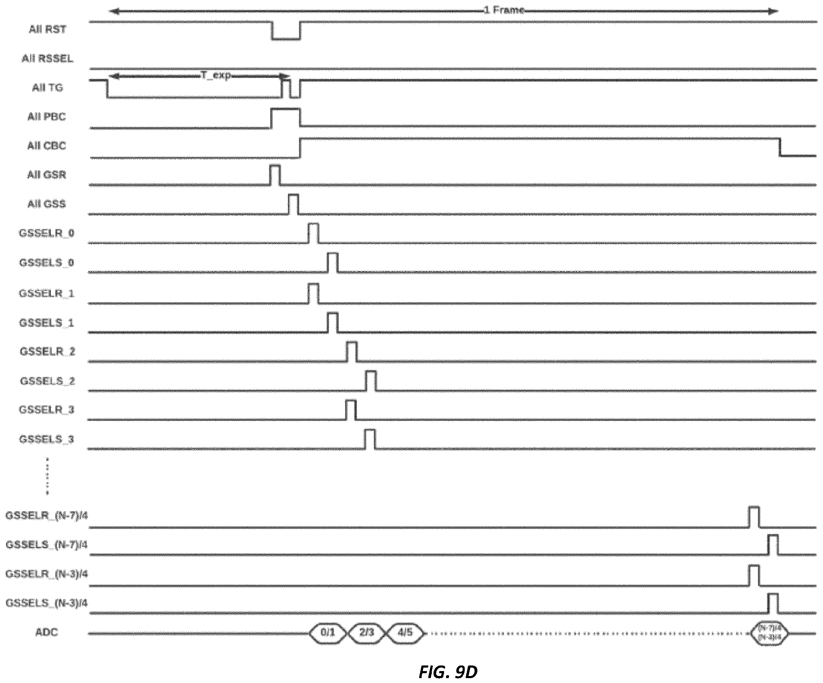

For example, to operate with a rolling shutter for full resolution, each of the photodiodes 802a-d may be connected to FD region 804 in sequence by asserting in any suitable sequence signals the transfer gate ("TG") signals TG_0,E, TG_0,O, TG_1,E, and TG_1,O (corresponding to rows 0 and 1 in the image sensor and the "even" and "odd" columns in the pixel array). When a photodiode 802a-d is connected to the FD region 804, the RSSEL_0 ("0" for the first row in the image sensor) signal may be asserted to close the corresponding switch 820 and output the rolling shutter output voltage, RS_0. As will be seen in Figure 9, the RS_0 signal is output to a corresponding column line, where it can be digitized and readout. The RSSEL_0 signal is then de-asserted and the FD region 804 is reset by asserting the RST_0 signal. The remaining photodiodes 802a-d can be readout in the same fashion. Successive rows of the image sensor may then each be exposed and readout accordingly.

In addition, CDS operation may be provided in the rolling-shutter mode. For example, a reset voltage may be obtained after the photodiodes are reset, but before any transfer gates is closed, by asserting RSSEL_0 (for example) and transferring the reset voltage to the column line. Subsequently, the transfer gates may be closed in sequence to obtain the corresponding output voltages from the photodiodes. The stored reset voltage may then be used to cancel any thermal noise component of the output voltage from the photodiode.

In contrast, to operate in a global shutter mode (with CDS, in this example), the FD region 804 is reset and the global shutter reset ("GSR") signal (for row 0 and the even column of the pixel arrays connected to the corresponding CDS component 840) is asserted to connect the output of the SF 806 to transfer the reset voltage to a corresponding CDS component 840. The GSR signal is then deasserted, following the integration period, all four of the photodiodes 802a-d may be connected to the FD region 804 by asserting all four TG signals to close the corresponding switches 810a-d. The global shutter signal ("GSS") signal is then asserted (GSS_0,E) to transfer the global shutter ("GS") voltage output by the SF 806 to the CDS component 840. And while this example is discussed with respect to the operation of a specific pixel array, it should be appreciated that these operations are performed simultaneously by all pixel arrays in the image sensor to provide a global shutter for the image sensor.

It should be appreciated that, while the example pixel array shown in FIG. 8A has a 2x2 array of photodiodes, any suitably sized pixel array may be employed. For example, pixel arrays of 2x4, 1x4, 1x2, etc. may be employed according to different examples.

Referring to FIG. 8B, an example CDS component 840 corresponding to the pixel array 800 in FIG. 8A is shown. In this example, the GR and GS signals are received from the pixel array 800 at corresponding reset and signal capacitors ("OR" and "CS," respectively). The reset and signal voltages may then be readout successively by asserting and deasserting the global shutter reset select signal ("GSSELR") and the global shutter signal select signal ("GSSELS"), the outputs of which are connect to a corresponding column line in this example.

Referring now to FIGs. 9A-9B, FIG. 9A shows a partial view of an example hybrid image sensor with multimode shutters. The view shown in Figure 9A includes a cluster 900 of four pixel arrays 800a-d. The image sensor includes multiple pixel arrays 800 arranged in a two-dimensional layout 910 as shown in FIG. 9B. The layout 910 includes regular arrangements of clusters of pixel arrays, with the cluster 900 of FIG. 9A in the upper left corner of the layout 910 and pixel array 800a identified. As can be seen in the layout 910, the clusters extend to the right and downward to any desired sensor size or resolution.

As discussed above with respect to FIGs. 8A-8B, the pixel arrays 800a-d are each coupled to the depicted column lines 920a-b by the RSSEL switches or via the CDS component 840 to enable readout of the pixel values. In rolling shutter operation, the timings of which are shown in Figure 9C, the pixel arrays 800a-b in the first row are integrated and readout first to their respective column lines, as discussed above: each pixel in the respective pixel arrays is sequentially connected to the FD region 804, which is then connected to the corresponding column line via the SF 806 and rolling shutter switch by asserting RSSEL. After the pixels in the first row have been readout, the pixels in the pixel arrays 800c-d in the second row may be integrated and readout in the same fashion. The remaining rows of pixels in the pixel sensor may then be readout in the same fashion to capture a full-resolution image.

By contrast, global shutter operation timing is shown in Figure 9D. In a global shutter, low-resolution mode, all four pixels in each pixel array in the cluster are connected to the respective FD region to "bin" their charges, which is then connected to the CDS component. In CDS mode, the pixels are first connected to the FD region 804 by asserting the TG signals and reset. The transfer gates are then opened and the exposure period begins. During the exposure period, the reset voltage is transferred to CR 842 in the corresponding CDS component 840 by asserting the GSR signal. After the voltage is transferred, the GSR signal is deasserted. The exposure period concludes, and the transfer gates are closed, transferring their voltages to the FD region 804. The GSSELS signal is then asserted to transfer the signal voltage to CS 844 in the corresponding CDS component 840. Once the reset and signal voltages have been stored in the CDS component 840, the voltages may be output to the corresponding column line 920a. The column lines 920a-b each transfer signals to a corresponding ADC 930a-b to generate a digital value for the corresponding voltage.

While the global shutter mode provides a global shutter, it also provides a lower resolution than the rolling shutter mode for this example. In a rolling shutter mode, all sixteen photodiodes in the four pixel arrays 800a-d will be discretely sampled to generate sixteen discrete pixel values. However, in the global shutter mode, each pixel array 800a-d will output a single aggregated value for all of the photodiodes in the respective pixel array 800a-d, and all four pixel arrays 800a-d are simultaneously connected to the CDS component 840 to combine and average their voltages at the CDS component 840, thus providing an average pixel value for the 16 separate photodiodes in the cluster 900. And while this example associates four pixel arrays 800a-d with each CDS component 840, any number of pixel arrays may be associated with a CDS component 840.

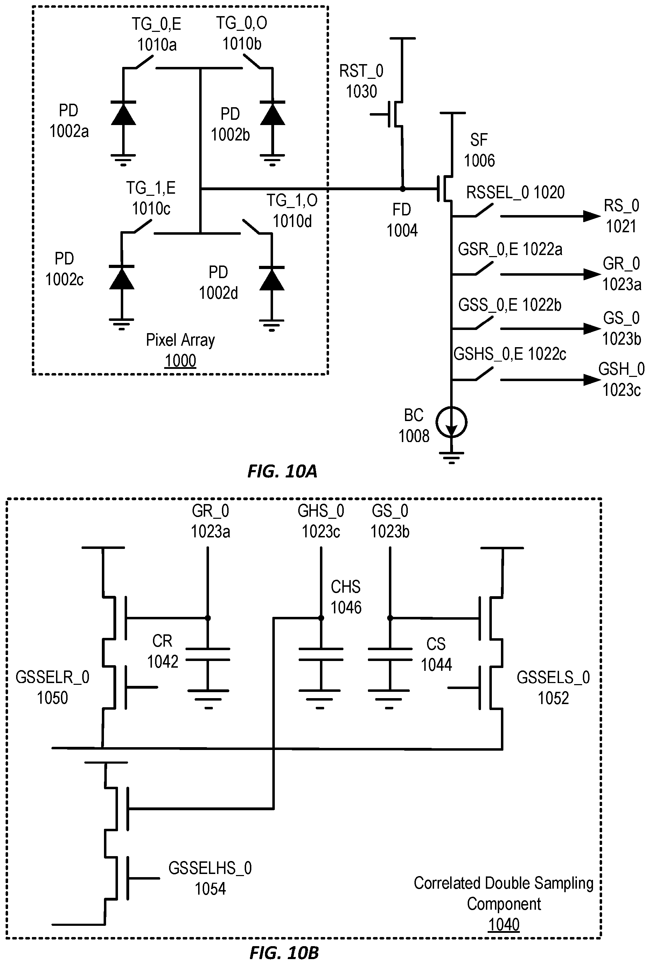

Referring now to FIGs. 10A-10B, FIG. 10A shows an example pixel array 1000 configured to provide a rolling shutter mode, a global shutter mode with CDS, and a global shutter mode with high dynamic range ("HDR") and CDS. Like the example shown in FIG. 8A, the pixel array 1000 includes four photodiodes 1002a-d that may be selectively connected to a FD region 1004, though the pixel array 1000 could be designed to have any number of photodiodes, depending on the application. SF 1006 provides an output from the FD region 1004 that may be transferred via one of four switches to different destinations. As with FIG. 8A, switch 1020 outputs RS 1021 to the corresponding column line for a rolling shutter mode of operation. In global shutter mode, GSR and GSS transfer reset and signal values 1023a-b to the CDS component for storage in CR 1042 and CS 1044 respectively. In addition, a third global shutter signal, global shutter HDR select ("GSHS"), transfers the voltage from SF 1006 to capacitor CHS in the CDS component 1040, as will be discussed in more detail below.

Operation in the HDR mode involves, after an exposure period, closing a single TG, e.g., TG 1010a, to obtain a "high light" value, which is transferred as GSH 1023c by asserting GSHS to close switch 1022c and couple the SF 1006 output to the CDS component 1040, as described below. The high light value can indicate whether corresponding PD 1002a-d saturated during the exposure period or whether it achieved a charge level leading to saturation of the FD 1004 when all charge from all four PDs 1002a-d are transferred to the FD 1004, e.g., the stored charge at the selected PD exceeded approximately 25% of the FD 1004 capacity. After the high light signal has transferred, the remaining three TGs 1010b-d are closed to connect the corresponding PDs 1002b-d to the FD 1004 to bin the charges from all four PDs 1002a-d as in normal global shutter CDS operation.

FIG. 10B shows the CDS component 1040 that corresponds to the pixel array 1000 shown in Figure 10A. As with the example CDS component 840 shown in Figure 8A, the CDS component 1040 includes CR 1042 and CS 1044 capacitors. In addition, the CDS component 1040 includes a third capacitor to store the GSH 1023c voltage. Each of the stored voltages may be output by closing a switch-GSSELR, GSSLES, or GSSELHS-to connect a corresponding source follower to a column line for readout.

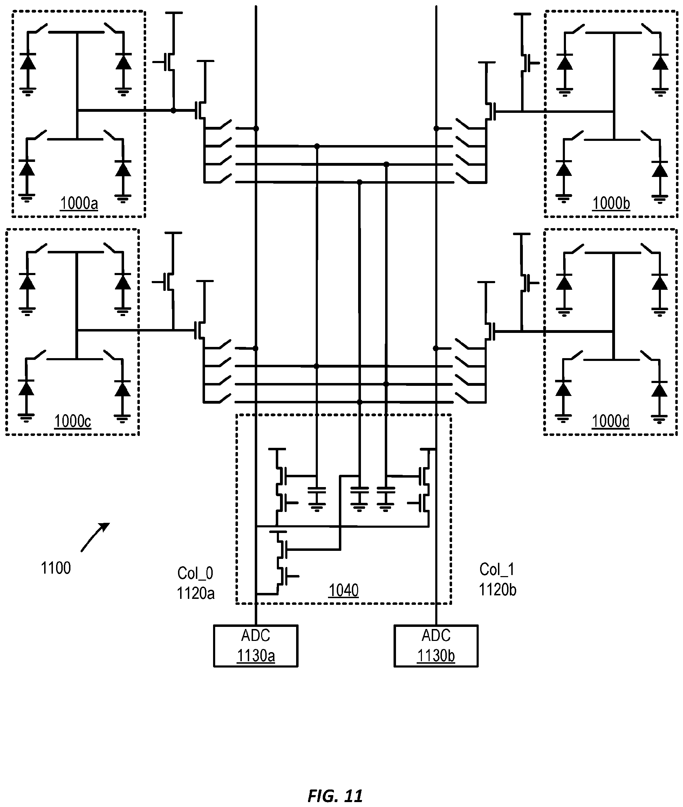

FIG. 11 shows a partial view of an example hybrid image sensor with multimode shutters. The view shown in Figure 11 includes a cluster 1100 of four pixel arrays 1000a-d of the type shown in Figure 10A. As with the example shown in Figure 9A, this example image sensor includes multiple pixel arrays 1000 arranged in a two-dimensional layout 910 as shown in FIG. 9B.

As discussed above with respect to FIGs. 10A-10B, the pixel arrays 1000a-d are each coupled to the depicted column lines 1120a-b by the RSSEL switches or via the CDS component 1040 to enable readout of the pixel values. In rolling shutter operation, the pixel arrays 1000a-b in the first row are integrated and readout first to their respective column lines: each pixel in the respective pixel arrays is sequentially connected to the FD region 1004, which is then connected to the corresponding column line via the SF 1006 and rolling shutter switch by asserting RSSEL. After the pixels in the first row have been readout, the pixels in the pixel arrays 1000c-d in the second row may be integrated and readout in the same fashion. The remaining rows of pixels in the pixel sensor may then be readout in the same fashion to capture a full-resolution image.

By contrast, in a global shutter, HDR, low-resolution mode, all four pixels in each pixel array are connected to the respective FD region, which is then connected to the CDS component. In CDS mode, similar to FIG. 9A described above, the pixels are first connected to the FD region 1004 and reset. The transfer gates are then opened and the exposure period begins. During the exposure period, the reset voltage is transferred to CR 1042 in the corresponding CDS component 1040 by asserting the GSR signal. After the voltage is transferred, the GSR signal is deasserted. The exposure period concludes, and the transfer gates are closed, transferring their voltages to the FD region 1004. The GSSELS signal is then asserted to transfer the signal voltage to CS 1044 in the corresponding CDS component 1040. Once the reset and signal voltages have been stored in the CDS component 1040, the voltages may be output to the corresponding column line 920a.

As discussed above with the example shown in Figures 9A-9B, all four pixel arrays 1000 a-d are simultaneously connected to the CDS component 1040 to combine and average their voltages at the CDS component 1040, thus providing an average pixel value for the 16 separate photodiodes in the cluster 1100. And while this example associates four pixel arrays 1000a-d with each CDS component 1040, any number of pixel arrays may be associated with a CDS component 1040.

To provide HDR operation in this example, two separate readout cycles are performed. The first ADC is done by reading out the reset value from CR first followed by the high light signal value from CHS. After a high light signal value is generated, a second ADC is done by reading out the same reset value of the pixel again from CR followed by the regular signal value from CS. A second regular signal value is generated after the second ADC cycle. In this example, the dynamic range can be extended by 4 times, or 12 dB. The HDR information contained within the high light signal value and the regular signal value can be sent off the sensor for off-chip processing. Conventional HDR combining and/or tone mapping algorithms can be applied to create an HDR image. An on-chip HDR processing unit, such as within the image signal processing unit, can also be implemented.

While this image sensor provides HDR functionality, it is not required. Instead, the sensor could operate in a global shutter CDS mode without HDR-a high light sample may be obtained before obtaining the full value for the pixel array. As discussed above with respect to Figure 10A, after the exposure period, a single photodiode 1000a in each pixel array 1000a-d may be connected to the corresponding FD region 1004 to transfer the photodiode's charge. The FD region may be connected to the CDS component to store the single photodiode's charge as GSH 1023c. The remaining three photodiodes may then be connected to the FD region 1004 to bin all four charges and then transfer them to the CS capacitor 1044 in the CDS component 1040. Each of the three stored values-the reset value GR, the HDR or high light value GHS, and the pixel array value GS-may then be readout in succession by closing the corresponding switches 1050-1054 in the CDS component 1040 to connect it to the respective column line. As with the example shown in Figure 9A, the global shutter mode provides a global shutter at a lower resolution than the rolling shutter mode for this example.

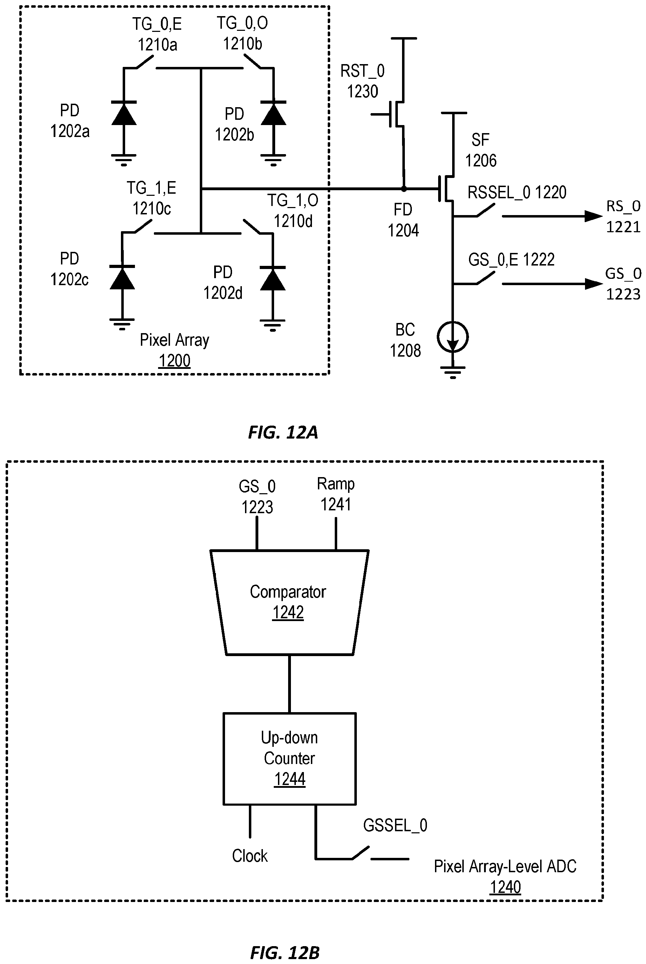

Referring now to FIGs. 12A-12B, FIG. 12A shows an example pixel array 1200 configured to provide a rolling shutter mode and a global shutter mode. Like the examples shown in FIGs. 8A and 10A, the pixel array 1200 includes four photodiodes 1202a-d that may be selectively connected to a FD region 1204, though the pixel array 1200 could be designed to have any number of photodiodes, depending on the application. SF 1206 provides an output from the FD region 1204 that may be transferred via one of two switches to different destinations. As with FIG. 8A, switch 1220 outputs RS 1221 to the corresponding column line for a rolling shutter mode of operation. In global shutter mode, however, GS transfers pixel array signal values 1223 to a pixel array-level ADC component 1240, shown in FIG. 12B. Thus, while this example provides both rolling and global shutter modes, the global shutter mode does not include a CDS component.

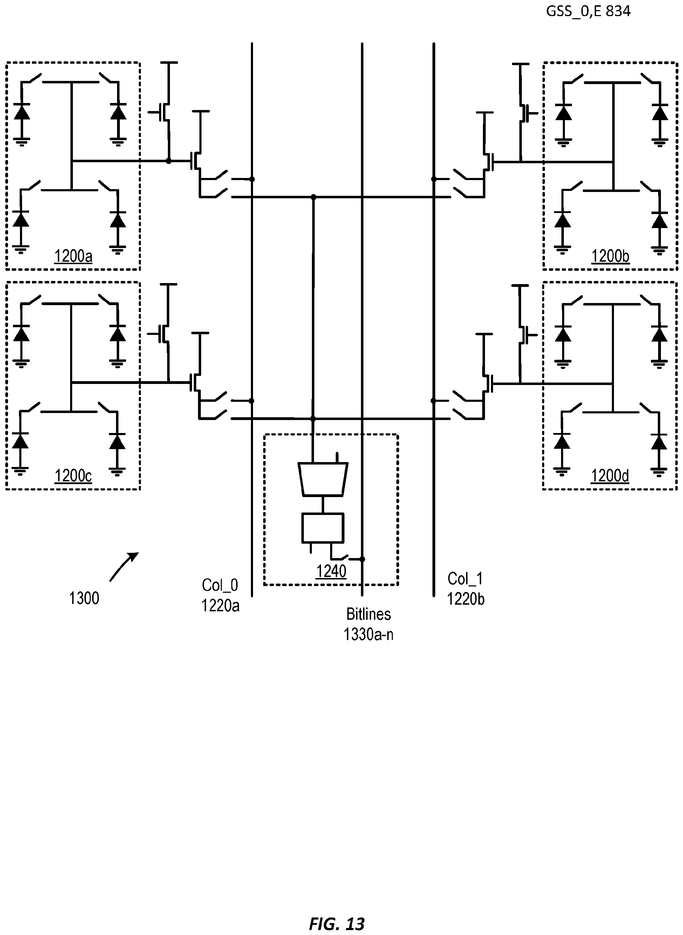

The pixel array-level ADC 1240 provides analog-to-digital conversion of values output by a pixel array, which may represent a single photodiode or a binned value of multiple photodiodes, e.g., all four photodiodes 1202a-d in this example. As with the examples discussed above with respect to FIGs. 8A and 10A, the global shutter mode operates in a low-resolution mode with a pixel array outputting a single pixel value representing binned charge from all photodiodes 1202a-d in the pixel array. During global shutter operation, all four photodiodes collect charge during an exposure period, after which all four TGs 1210a-d are closed to transfer charge from all four photodiodes 1202a-d to the FD region 1204. The global shutter ("GS") signal is asserted for the pixel array 1200, closing the global shutter switch 1222 to transfer the voltage to the corresponding pixel array-level ADC 1240, which can generate a pixel value and output it to a corresponding column line. As will be discussed with respect to Figure 13, multiple pixel arrays may share a single pixel array-level ADC 1240, though in some examples each pixel array may have a dedicated pixel array-level ADC 1240.

The pixel array-level ADC 1240 includes a comparator 1242 that receives the GS signal 1223 from the pixel array 1200 and compares it to a ramp signal 1241. In examples that employ CDS, reset and signal voltages may be provided, in sequence, to the pixel-array-level ADC 130. To provide digital values representing the reset and signal values, an up-down counter is used in this example. The counter value may then be output to a corresponding column line by asserting the appropriate GSSEL signal. Thus, this example configuration enables rolling shutter operation, generally as described above with respect to FIGs. 8A and 10A, as well as low-resolution global shutter operation using a dedicated pixel array-level ADC.

FIG. 13 shows a partial view of an example hybrid image sensor with multimode shutters. The view shown in Figure 13 includes a cluster 1300 of four pixel arrays 1200a-d of the type shown in Figure 12A. As with the example shown in Figure 9A, this example image sensor includes multiple pixel arrays 1000 arranged in a two-dimensional layout 910 as shown in FIG. 9B.

In this example, the image sensor can be operated in a rolling shutter mode generally as described above with respect to FIG. 11. Alternatively, it can be operated in a global shutter mode. In a global shutter mode, as discussed above, before the beginning of an exposure period, the photodiodes 1202a-d and FD region 1204 are reset and, during the exposure period, the photodiodes 1202a-d accumulate charge. After the exposure period, all TGs 1212a-d are closed to transfer and bin charge from the photodiodes 1202a-d at the FD region 1204. The global shutter switch 1222 is then closed, transferring the pixel array value GS 1223 to the pixel array-level ADC 1240, where the pixel array value GS 1223 is converted to a digital value and output to the bitlines 1330a-n. In this example, the cluster 1330 includes four pixel arrays 1200a-d, which operate simultaneously during the same exposure period. As discussed above with respect to Figures 9 and 11, each of the four pixel arrays 1200a-d are simultaneously connected to the ADC 1240 to provide an average value for the 16 photodiodes within the cluster 1300. The pixel arrays are then reset for the next image frame.

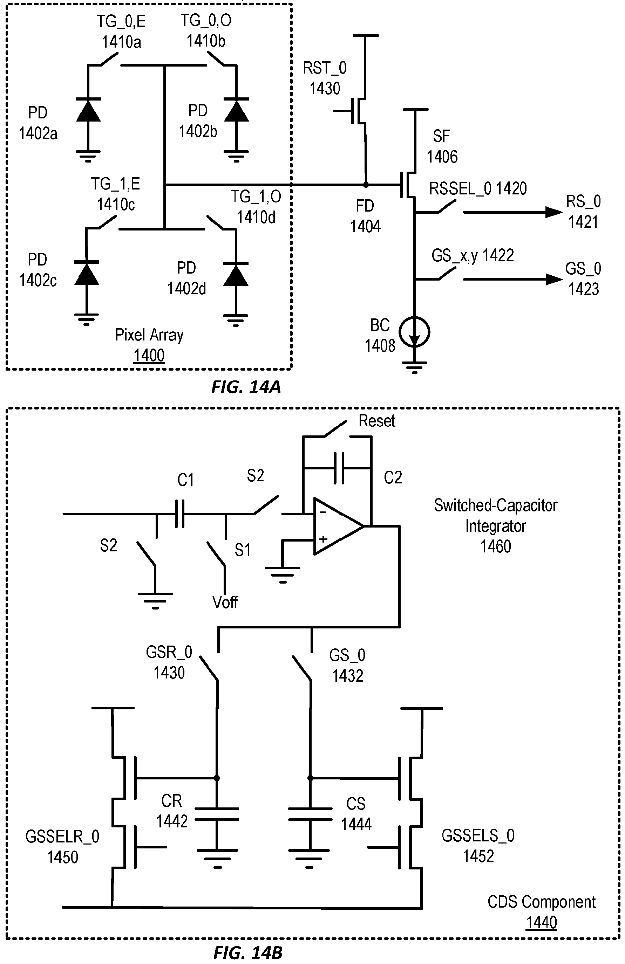

Referring now to FIGs. 14A-14B, Figure 14A shows an example pixel array 1400 similar to the pixel array 1200 shown in Figure 12A. As with the pixel array 1200, the pixel array 1400 includes four photodiodes 1402a-d connected by TGs 1410a-d to a charge storage device, FD region 1404. In a rolling shutter configuration, the photodiodes 1402a-d each accumulate charge during respective exposure periods, which like the other examples discussed herein, that may be staggered in time or may occur simultaneously. Each photodiode 1402a-d is connected in sequence to the FD region 1404 after its exposure period has completed. In addition, the RSSEL signal is asserted, closing switch 1420 and coupling the output of the SF 1406 to a corresponding column line for the outputted voltage to be transferred to a column-level ADC for conversion to a digital value. Thus, the charge level of each photodiode 1402a-d is readout and converted in sequence before being reset.

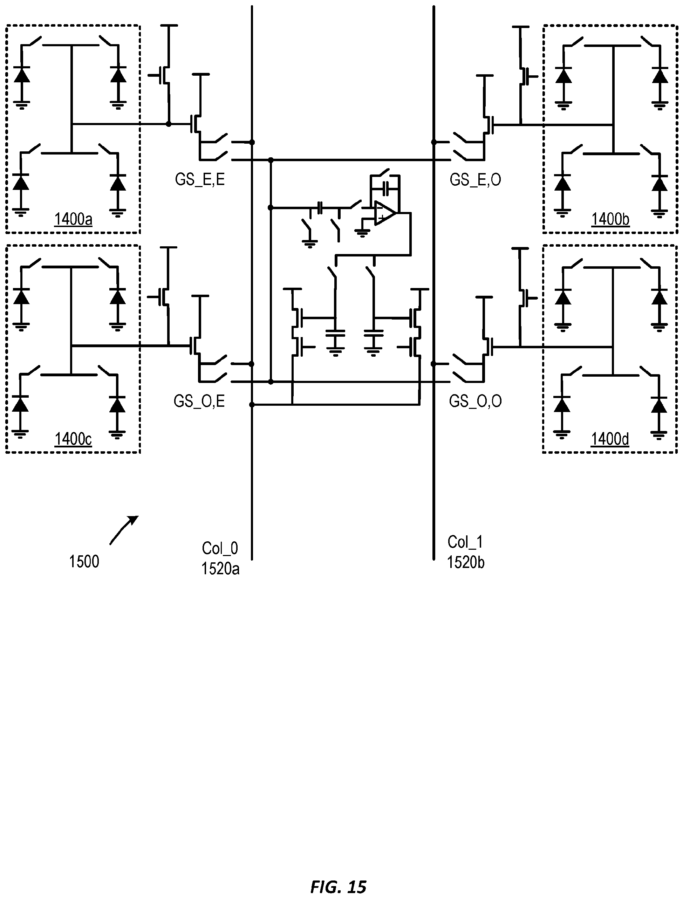

In the global shutter mode, the pixel array's reset voltage is first sampled by closing the four TG switches 1410a-d and asserting the GS signal to transfer the pixel array reset value to the CDS component 1440. In the example to be described in FIG. 15, the CDS component is shared by four pixel arrays, and the reset values of each of the pixel arrays will be transferred to the CDS component 1440 in sequence and integrated, as will be discussed below. The integrated reset value is stored in capacitor CR 1442. The photodiodes then accumulate charge during an exposure period and transfer and bin their charges to the FD region 1404. The GS_x,y signal is asserted again to transfer the pixel array's voltage to the CDS component, which integrates the received pixel values, in sequence, from the four connected pixel arrays. The integrated pixel array value is then stored in capacitor CS 1444. The reset and pixel array values may then be output to a corresponding column line by asserting and deasserting the GSSELR and GSSELS signals in sequence.

FIG. 14B shows an example CDS component 1440 that includes storage capacitors CR 1442 and CS 1444, similar to the CR and CS capacitors shown in, for example, FIG. 8B. In addition, the CDS component 1440 includes a switched-capacitor integrator 1460 to integrate pixel array values received from the pixel arrays 1400a-d connected to the CDS component. In global shutter mode, the pixel array is reset, the transfer gates are opened and the integration period begins. The reset voltage is then transferred to the CDS component, which integrates and stores the resulting voltage in the CR capacitor 1442. During the exposure period, the pixel array accumulates charge and, after the exposure period ends, the transfer gates are closed and the photodiodes 1402a-d bin their charges at the FD region 1408 before the resulting voltage is transferred to the input of the switched-capacitor integrator 1460. As with the reset voltage, the pixel array voltage is transferred and integrated, with the integrated voltage stored in the CS capacitor 1444. The reset and pixel values may then be read in sequence by asserting and deasserting the GSSELR and GSSELS signals.

Referring to FIG. 15, FIG. 15 shows a partial view of an example hybrid image sensor with multimode shutters. The view shown in Figure 15 includes a cluster 1500 of four pixel arrays 1400a-d of the type shown in Figure 14A. As with the example shown in Figure 9A, this example image sensor includes multiple pixel arrays 1000 arranged in a two-dimensional layout 910 as shown in FIG. 9B.

In this example, the image sensor is configured to for both a full resolution, rolling shutter mode and a global shutter pixel array averaging mode. The full-resolution rolling shutter mode operates in the same manner as the rolling shutter mode described above with respect to, for example, FIG. 8A. In the global shutter mode, however, the outputs of all four pixel arrays 1400a-d associated with the CDS component are binned and integrated, reducing the resolution of the image sensor by a factor of sixteen, but increasing the sensitivity of the sensor by the same factor. Thus, the loss of resolution is exchanged for increased low-light sensitivity.

In global shutter mode, each of the pixel arrays 1400a-d is reset and connected, in sequence, to the CDS component to transfer the voltages output by their respective SF 1408 to the input of the switched-capacitor integrator, which integrates the reset voltages and outputs the resulting voltage to the CR capacitor 1442. In addition, each of the pixel arrays 1400a-d accumulates charge during a common exposure period and, after the exposure period, bins the resulting charges in their respective FD regions 1408. The pixel arrays 1400a-d are then connected, in sequence, to the CDS component to transfer the voltages output by their respective SF 1408 to the input of the switched-capacitor integrator, which integrates and outputs the resulting voltage to the CS capacitor 1444.

The operation starts by first sampling the even row, even column pixel reset value (GS_E,E is on) with the sampling switch S1 and amplifier reset switch enabled. The reset value, Vrst1, for the first pixel array 1400a in the cluster 1500 is sampled on C1 (Vrst1 - Voff) and the voltage across C2 is zero with an infinite gain amplifier. After Vrst1 is sampled, S1 and the amplifier reset switch are turned off and the amplification switches S2 are turned on. During the amplification phase, the charge transfer from C1 to C2 exhibits a voltage of (Vrst1 - Voff) x (C1/C2) at the output of the switched-capacitor integrator. After Vrst1 is integrated into the output, the even row, odd column pixel reset value (GS_E,O is on) will be sampled with S1 turned on. The reset value, Vrst2, for the corresponding pixel array 1400b is sampled on C1 (Vrst2 - Voff) while the voltage across C2 remains as (Vrst1 - Voff) x (C1/C2). After Vrst2 is sampled, S1 and the amplifier reset switch are turned off and the amplification switches S2 are turned on again. During the amplification phase, the charge transfer from C1 to C2 enables the SC integrator to add the second reset value (Vrst2 - Voff) x (C1/C2) to the previously established value (Vrst1 - Voff) x (C1/C2). Once the amplification completes, the output of the switched-capacitor integrator becomes (Vrst1 + Vrst2 - 2 × Voff) × C1/C2). This operation continues until all four reset values of the four pixel arrays 1400a-d are integrated on the switched-capacitor integrator output as (Vrst1 + Vrst2 + Vrst3 + Vrst4 - 4 x Voff) x (C1/C2). This value will be sampled on the reset capacitor CR 1442 with GSR enabled.

Once the voltage-binned reset value is sampled, charge transfer occurs by enabling all TG signals and the exposure ends. The signal values of all four pixel arrays 1400a-d will be integrated in the same manner as the reset values through the same switched-capacitor integrator, and the voltage-binned signal value will be sampled on the signal capacitor CS 1444 as (Vsig1 + Vsig2 + Vsig3 + Vsig4 - 4 x Voff) x (C1/C2) with GSS enabled. When the reset and signal values are read out by the ADC, the CDS operation will remove the noise components of each 4-shared pixel unit, resulting in a pixel value [(Vsig1 + Vsig2 + Vsig3 + Vsig4) - (Vrst1 + Vrst2 + Vrst3 + Vrst4)] x (C1/C2). When C1 equal C2, the pixel value is [(Vsig1 + Vsig2 + Vsig3 + Vsig4) - (Vrst1 + Vrst2 + Vrst3 + Vrst4)], representing the voltage-binned value of the four pixel arrays. Further, it is possible to use a different C1/C2 ratio as a programmable gain amplifier during the voltage binning operation.

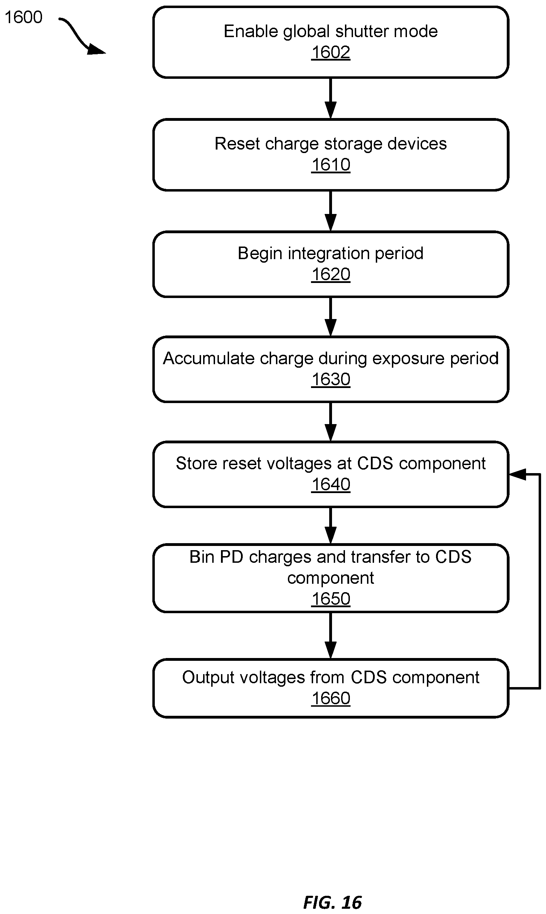

Referring now to FIG. 16, FIG. 16 shows an example method 1600 for hybrid image sensors with multimode shutters. The example method 1600 will be discussed with respect to the image sensor shown in Figure 9A; however, any suitable image sensor according to this disclosure may be employed.

At block 1602, the image sensor enables a global shutter mode for the image sensor. In this example, the global shutter mode may be enabled by a controller for the image sensor, such as controller 606, based on a command from another device, such as host processor 604.

At block 1610, the image sensor resets the charge storage devices 904 of the pixel arrays 900a-d. In this example, the image sensor closes all transfer gates by asserting all TG_x,y signals and asserts a reset signal for each pixel array 900a-d to reset the photodiodes and charge storage devices of the pixel arrays 900a-d. As discussed above with respect to Figure 11, the charge storage devices 900a-d in this example are FD regions 904, though any suitable charge storage device may be employed.

At block 1620, the image sensor opens the transfer gates and begins the integration period for an image frame. In some examples, the reset voltages may be sampled while integration occurs; however, the reset voltages may instead be sampled before integration begins.

At block 1630, the light-sensing elements 902a-d of the pixel arrays accumulate charge during an integration period.

At block 1640, the image sensor transfers, for each pixel array 900a-d, a reset voltage stored at the charge storage device 904 to a corresponding CDS component 940. In this example, the image sensor asserts a GSR signal to close a corresponding switch 922a to connect the output of the SF 906 to the CR capacitor 942 of the CDS component 940 for a respective pixel array 900a.

At block 1650, the image sensor transfers, for each pixel array, accumulated charge from each light-sensing element to the corresponding charge storage device, e.g., FD region 904. In this example, the image sensor enables all transfer gates by asserting all TG_x,y signals, which bins charge from all light-sensing elements in a particular pixel array 900a-d at the corresponding charge storage device, e.g., FD region 904, where they are stored as a signal voltage for the pixel array 900a-d. After the charges are binned at the charge storage device, the image sensor asserts a GSS signal to close the corresponding GSS switch 922b in the pixel array and transfer the stored signal voltage to the CS capacitor 944 in the CDS component.

At block 1650, the voltages stored in the CDS are output to a corresponding column line, e.g., column line 1120a. In this example, the reset voltage is transferred by asserting a corresponding GSSELR signal. The GSSELR signal is then deasserted and the corresponding GSSELS signal is then asserted to transfer the signal voltage to the column line 1120a. Finally, in an example that has enabled HDR capability in the global shutter mode, the corresponding GSSELHS signal is asserted to transfer the high-light signal voltage to the column line. Voltages transferred to a corresponding column line may then be converted to a digital value by a column ADC 1130a. In some examples, the reset and signal voltages may be subtracted in the analog domain before ADC is performed. Though in some examples, both voltages may be converted to digital values before subtraction occurs.

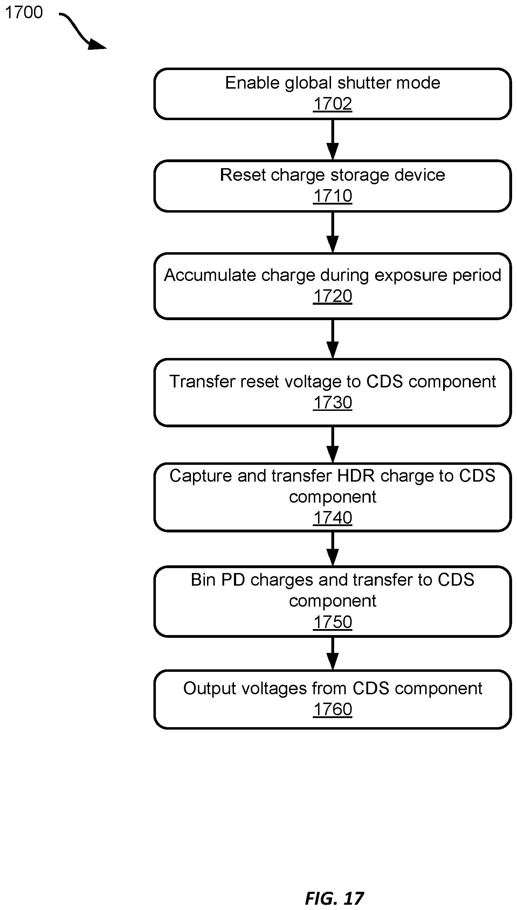

Referring now to FIG. 17, FIG. 17 shows an example method 1700 for hybrid image sensors with multimode shutters. The example method 1700 will be discussed with respect to the image sensor shown in Figure 11; however, any suitable image sensor according to this disclosure may be employed.

At block 1702, the image sensor enables a global shutter mode for the image sensor generally as described above with respect to block 1602. However, in this example, the image sensor is configured with optional HDR functionality in the global shutter mode. Thus, in this example, the image sensor enables the global shutter mode with HDR. However, image sensors configured for optional HDR functionality may enable a global shutter mode without enabling HDR functionality, which may then function generally as described above with respect to FIG. 16.

At block 1710, the image sensor resets the charge storage devices 1004 of the pixel arrays 1000a-d, generally as discussed above with respect to block 1610.

At block 1720, the light-sensing elements 1002a-d of the pixel arrays accumulate charge during an integration period, generally as described above with respect to block 1620.

At block 1730, the image sensor transfers, for each pixel array 1000a-d, a reset voltage stored at the charge storage device 1004 to a corresponding CDS component 1040 and begins the integration period, generally as described above with respect to block 1620.

At block 1740, after the integration period, the image sensor transfers accumulated charge for one light sensing element, e.g., photodiode 1002a, to the charge storage device 1004. In this example, the image sensor asserts even column and row TG signals to close the transfer gate 1010a for one photodiode 1002a in each pixel array and transfer the accumulated charge for the photodiode 1002a to the FD region 1004. The accumulated charge for the single photodiode 1002 is stored as a high-light signal voltage at the FD region 1004.

After the high-light signal voltage has been transferred to the FD region 1004, the image sensor asserts a GSHS signal to transfer the stored high-light voltage signal, which is output by SF 1006, to a CHS capacitor 1046 in a corresponding CDS component, where the high-light voltage signal is stored. It should be appreciated that block 1740 may be omitted in image sensors that are not configured with CDS components that have a CHS capacitor 1046, such as the example image sensor shown in FIG. 9A, or that are not operating in a global shutter mode with HDR, such as described above with respect to FIG. 16.

At block 1750, the image sensor transfers, for each pixel array, accumulated charge from each light-sensing element to the corresponding charge storage device, e.g., FD region 1004. In this example, the image sensor enables all remaining open transfer gates by asserting all unasserted TG_x,y signals, which bins charge from all light-sensing elements in a particular pixel array 1000a-d at the corresponding charge storage device, e.g., FD region 1004, where they are stored as a signal voltage for the pixel array 1000a-d. After the charges are binned at the charge storage device, the image sensor asserts the GSS signals for each pixel array 1000a-d to transfer and average the stored signal voltages to the CS capacitor 1044 in the CDS component.

At block 1760, the voltages stored in the CDS are output to a corresponding column line, e.g., column line 1120a. In this example, the reset voltage is transferred by asserting a corresponding GSSELR signal. The GSSELR signal is then deasserted and the corresponding GSSELS signal is then asserted to transfer the signal voltage to the column line 1120a. Finally, the corresponding GSSELHS signal is asserted to transfer the high-light signal voltage to the column line. Voltages transferred to a corresponding column line may then be converted to a digital value by a column ADC 1130a. And while the voltages were transferred out in a particular order in this example, they may be transferred in any suitable order.

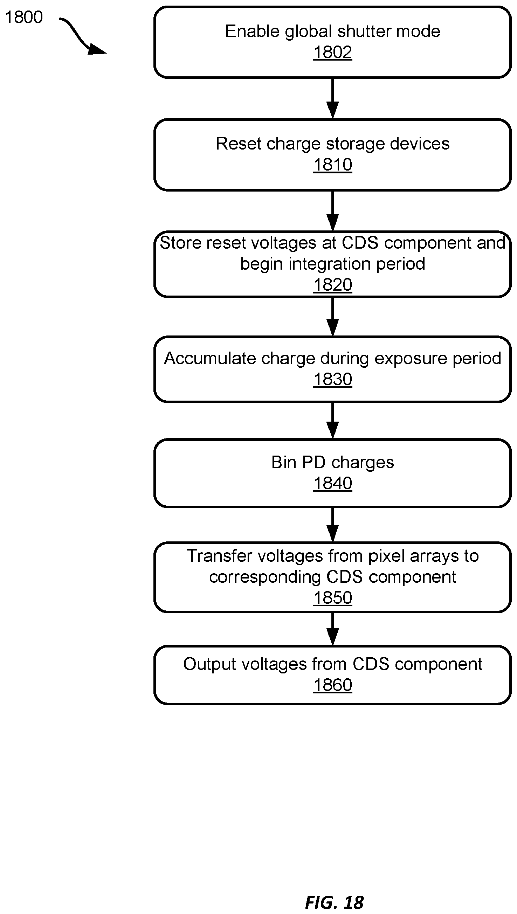

Referring now to FIG. 18, FIG. 18 shows an example method 1800 for hybrid image sensor with multimode shutters. The example method will be described with respect to the image sensor shown in FIG. 9A; however, any suitable image sensor according to this disclosure may be employed.

At block 1802, the image sensor enables a global shutter mode for the image sensor generally as described above with respect to block 1602. However, in this example, the image sensor is configured with optional voltage averaging functionality in the global shutter mode. Thus, in this example, the image sensor enables the global shutter mode with voltage averaging.

Blocks 1810-1830 are generally as described above with respect to FIG. 16.

At block 1840, the image sensor transfers, for each pixel array, accumulated charge from each light-sensing element to the corresponding charge storage device, e.g., FD region 904. In this example, the image sensor enables all transfer gates by asserting all TG_x,y signals, which bins charge from all light-sensing elements in a particular pixel array 900a-d at the corresponding charge storage device, e.g., FD region 904, where they are stored as a signal voltage for the pixel array 900a-d.

At block 1850, the image sensor asserts the GSS signal for all pixel arrays to transfer and average the voltages from the pixel arrays at the corresponding CDS component. Thus, the CS capacitor 844 stores an average voltage for the four associated pixel arrays 800a-d. Such an approach reduces the resolution of image sensor to 1/16 of its full resolution, but can reduce the impact of noise on the image.

At block 1860, the reset and signal voltages are output generally as described above with respect to block 1650.

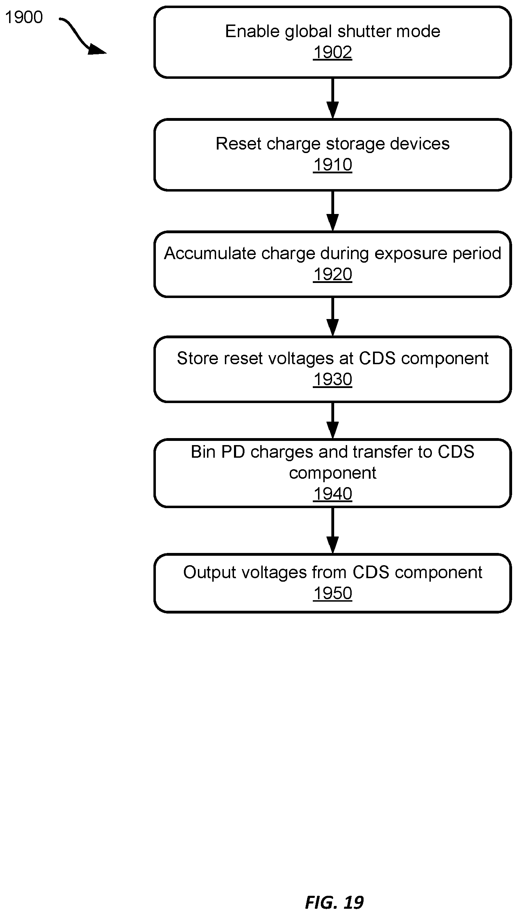

Referring to FIG. 19, FIG. 19 shows an example method 1900 for hybrid image sensor with multimode shutters. The example method will be described with respect to the image sensor shown in FIG. 15; however, any suitable image sensor according to this disclosure may be employed.

Blocks 1902 and 1910 proceed generally as discussed above with respect to blocks 1602 and 1610, respectively.

At block 1920, the pixel arrays 1400a-d accumulate charge during an exposure period, generally as discussed above with respect to block 1620.

At block 1930, the image sensor stores reset voltages at the CDS component 1440. In this example, the CDS component 1440 includes a switched capacitor integrator 1460 which is selectively connectable to the pixel arrays by a switch that is closed by a GS_x,y signal, as opposed to the examples shown in FIGs. 9A and 11, which have separate switches to transfer reset and signal voltages to the corresponding CDS component 940, 1140.

To store the reset voltage at the CDS component 1440, the image sensor asserts the GS_x,y signal for a pixel array 1400a to connect the particular pixel array 1400a to the input of the switched capacitor integrator. It also asserts a GSR signal to connect the output of the switched capacitor integrator 1460 to the CR capacitor in the CDS component. To complete the integration of the reset voltages, it then asserts, in sequence, the remaining GS_x,y signals for the other pixel arrays 1400b-d to connect them to the input of the switched capacitor integrator 1460.

At block 1940, the exposure period ends and the image sensor transfers charge from the light-sensing elements to the charge storage device in the pixel arrays, generally as described above with respect to block 1650. However, as discussed above with respect to block 1930, to transfer the voltage stored at the charge storage device to the CDS component 1440, the image sensor asserts a GS_x,y signal for one of the pixel arrays 1400a associated with the CDS component 1440 and asserts the corresponding GSS signal to connect the output of the switched capacitor integrator 1460 to the CR capacitor 1444. To complete the integration of the signal voltages, it then asserts, in sequence, the remaining GS_x,y signals for the other pixel arrays 1400b-d to connect them to the input of the switched capacitor integrator 1460.

At block 1950, the image sensor outputs the voltages as described above with respect to block 1660.

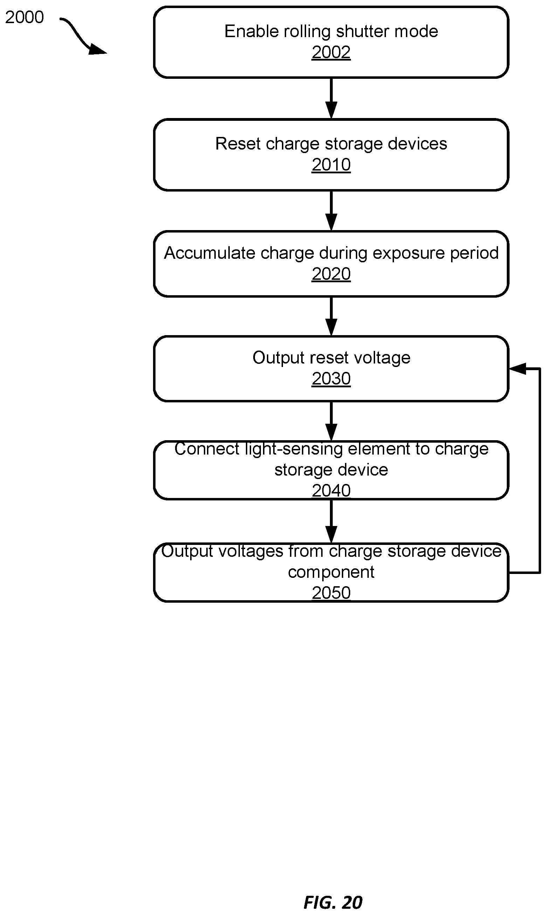

Referring now to FIG. 20, FIG. 20 shows an example method 2000 for hybrid image sensor with multimode shutters. The example method will be described with respect to the image sensor shown in FIG. 9A; however, any suitable image sensor according to this disclosure may be employed.

At block 2002, the image sensor enables a rolling shutter mode. In this example, the rolling shutter mode may be enabled by a controller for the image sensor, such as controller 606, based on a command from another device, such as host processor 604.

At block 2010, the image sensor resets the charge storage devices 804 generally as described above with respect to block 1610.

At block 2020, the light sensing elements accumulate charge during corresponding exposure periods. In this example the light sensing elements stagger their exposure periods to allow a preceding light sensing element to transfer its charge to the charge storage device and for the resulting voltage to be transferred to the corresponding column line. However, in some examples, each of the light sensing elements may begin their exposure periods at the same time.

At block 2030, the RSSEL_0 signal is asserted to transfer the reset voltage to the column line to support CDS operations. If CDS is not employed, this step may be omitted. Because block 2030 may be revisited multiple times during a single sampling operation, the charge storage devices 804 may be reset each time block 2030 is performed before a new reset voltage is read out.

At block 2040, the pixel array connects a first light-sensing element 802a to the charge storage device 804 by asserting a corresponding TG_x,y signal to close a corresponding transfer gate 810a.

At block 2050, the pixel array connects the output of its SF 806 to the corresponding column line 920a by asserting the corresponding RSSEL_X signal close row-select switch 820 to transfer the signal voltage RS_X 821 to the column ADC. After which the method returns to block 2030 or 2040, depending on whether CDS operation is employed. If CDS operation is used, the method returns to block 2030. Otherwise, the method returns to block 2040 to transfer charge for the next light-sensing element 802b-d in the pixel array 800 and transfer the resulting voltage to the column line. Once all light-sensing elements in the pixel array 800a have been readout, image capture is complete.

FIGS. 16-20 have all been described in the context of one set of pixel arrays and a corresponding CDS component. However, example image sensors will include many sets of pixel arrays and CDS components. Thus, the methods may be performed for all pixel arrays and CDS components within an image sensor to capture an image.

The foregoing description of some examples has been presented only for the purpose of illustration and description and is not intended to be exhaustive or to limit the disclosure to the precise forms disclosed.

Reference herein to an example or implementation means that a particular feature, structure, operation, or other characteristic described in connection with the example may be included in at least one implementation of the disclosure. The disclosure is not restricted to the particular examples or implementations described as such. The appearance of the phrases "in one example," "in an example," "in one implementation," or "in an implementation," or variations of the same in various places in the specification does not necessarily refer to the same example or implementation. Any particular feature, structure, operation, or other characteristic described in this specification in relation to one example or implementation may be combined with other features, structures, operations, or other characteristics described in respect of any other example or implementation.

Use herein of the word "or" is intended to cover inclusive and exclusive OR conditions. In other words, A or B or C includes any or all of the following alternative combinations as appropriate for a particular usage: A alone; B alone; C alone; A and B only; A and C only; B and C only; and A and B and C.

## Claims

1. A sensor apparatus comprising:
a plurality of pixel arrays, each array of pixels comprising a plurality of pixels, each pixel comprising a light-sensing element configured to generate and store a charge in response to incoming light;
each pixel array comprising:
a charge storage device configured to receive charge from each of the light-sensing elements of the pixel array;
a first plurality of switches, each switch of the first plurality of switches connected between a respective pixel of the pixel array and the charge storage device;
a second plurality of switches, the second plurality of switches comprising a high-resolution selection switch and a low-resolution selection switch, each of the high-resolution selection switch and the low-resolution selection switch connected in parallel to an output of the charge storage device;
a plurality of pixel output lines, each pixel output line configured to output signals representative of pixel values corresponding to one or more pixel arrays coupled to the respective pixel output line.

2. The sensor apparatus of claim 1, further comprising:
a plurality of analog-to-digital converters, "ADCs", each ADC connected to an output of a respective pixel output line.

3. The sensor apparatus of claim 1 or claim 2, further comprising, for each pixel array, a correlated double sampling, "CDS", component, the CDS component comprising:
a CDS reset value storage device, and
a CDS pixel value storage device; and
wherein:
the second plurality of switches further comprises a CDS reset value switch connected to the output of the charge storage device in parallel to the high-resolution selection switch and the low-resolution selection switch,
the CDS reset value switch connecting the charge storage device to a corresponding CDS reset value storage device,
the low-resolution selection switch connecting the charge storage device to the CDS pixel value storage device,
an output of the CDS reset value storage device connected to a respective pixel output line, and
an output of the CDS pixel value storage device connected to the respective pixel output line; and
wherein the sensor apparatus is configured to operate in a CDS mode and is configured to, for one or more pixel arrays:
close and open a respective CDS reset value switch to sample a reset voltage by the CDS reset value storage device;
close and open the switches of the first plurality of switches to transfer charges from the light-sensing elements to the respective charge storage device and close and open the respective resolution pixel value switch to sample a pixel voltage by the CDS pixel value storage device,
and optionally wherein a subset of the plurality of pixel arrays share a respective CDS component, and wherein the subset of pixel arrays are configured to be simultaneously connected to a respective CDS to provide voltage averaging for the subset of pixel arrays.

4. The sensor apparatus of claim 3, wherein the sensor apparatus is further configured to selectively close and open the high-resolution selection switch in sequence when each switch of the first plurality of switches is sequentially selectively closed to obtain a pixel value for each respective light-sensing element.

5. The sensor apparatus of claim 3 or claim 4, wherein the sensor apparatus is further configured to:
selectively close the CDS reset switch while the first plurality of switches of a respective array of pixels are open to store a reset pixel value in the CDS reset value storage device; and
selectively close the CDS selection switch while the first plurality of switches of a respective array of pixels are closed to store a pixel value in the CDS pixel value storage device.

6. The sensor apparatus of any of claims 3 to 5, further comprising, for each pixel array, a high-intensity pixel value storage device, and wherein
the second plurality of switches further comprises a high-intensity pixel value switch, and
the high-intensity pixel value switch connecting the charge storage device to a corresponding high-intensity pixel value storage device, and
wherein the sensor apparatus is configured to operate in a high-intensity CDS mode and is configured to, for one or more pixel arrays:
close and open a respective CDS reset value switch to sample a reset voltage by the CDS reset value storage device;
close and open a first switch of the respective first plurality of switches to transfer a first charge from a first light-sensing element to the respective charge storage device and close and open the respective high-intensity pixel value switch to sample a high-intensity voltage by the high-intensity pixel value storage device;
close and open the remaining switches of the first plurality of switches to transfer charges from the remaining light-sensing elements to the respective charge storage device and close and open the respective resolution pixel value switch to sample a pixel voltage by the CDS pixel value storage device.

7. The sensor apparatus of any of claims 3 to 6, further configured to perform voltage binning for groups of pixel arrays.

8. The sensor apparatus of any preceding claim, further comprising one or more correlated double sampling, "CDS", components, each CDS component comprising a comparator and an up-down counter, an input of the comparator connected to one or more low-resolution selection switches of one or more corresponding pixel arrays.

9. The sensor apparatus of any preceding claim, wherein:
the sensor apparatus is configured to operate in a high-resolution rolling-shutter mode or a low-resolution global-shutter mode, and wherein the sensor apparatus is configured to:
sequentially selectively close each switch of the first plurality of switches for each array of pixels in the high-resolution rolling-shutter mode; and
simultaneously close each switch of the first plurality of switches for each array of pixels in the low-resolution global-shutter mode,
and/or wherein each pixel array each comprises four light-sensing elements.

10. The sensor apparatus of any preceding claim, further comprising one or more correlated double sampling, "CDS", components, each CDS component comprising a switched-capacitor integrator, a CDS reset value storage device, and a CDS pixel value storage device, wherein the CDS reset value storage device and the CDS pixel value storage device are selectively couplable to an output of the switched-capacitor integrator,
and optionally wherein subsets of the plurality of pixel arrays are associated with a respective one of the CDS components.

11. The sensor apparatus of any preceding claim, wherein each pixel array comprises four light-sensing elements arranged in a 2x2 grid.

12. A method comprising:
enabling, in an image sensor having at least a rolling-shutter mode and a global-shutter mode, the global shutter mode, the image sensor having a plurality of pixel arrays, each pixel array comprising a plurality of light-sensing elements and a charge storage device configured to receive charge from each of the light-sensing elements of the pixel array, the light-sensing elements selectively connectable to the charge storage device;
resetting the charge storage devices of the image sensor to establish a reset voltage;
transferring, for each pixel array, a reset voltage to a corresponding correlated double sampling, "CDS", component;
accumulating, during an integration period, charge within each of the light-sensing elements of the pixels arrays;
transferring, for each pixel array, accumulated charge from each light-sensing element to the corresponding charge storage device to store as a signal voltage;
transferring, for each pixel array, the signal voltage from the corresponding charge storage device to a corresponding CDS component;
outputting the reset voltage and the signal voltage from the corresponding CDS component.

13. The method of claim 12, further comprising:
transferring, for each pixel array, accumulated charge from one light-sensing element to the corresponding charge storage device to store as a high-light signal voltage;
transferring, for each pixel array, the high-light signal voltage to the corresponding CDS component; and
outputting, for each pixel array, the high-light signal voltage from the corresponding CDS component,
and/or the method further comprising:
simultaneously transferring and averaging, for each CDS component, the signal voltages from all pixels arrays corresponding to the respective CDS component to the respective CDS component.

14. The method of claim 12 or claim 13, wherein each CDS component comprises a switched-capacitor integrator, and further comprising:
receiving and integrating, by each CDS component from the corresponding pixel arrays, the reset voltages;
storing, by each CDS component, the integrated reset voltage as the reset voltage;
receiving and integrating, by each CDS component from the corresponding pixel arrays, the signal voltages; and
storing, by each CDS component, the integrated reset voltage as the reset voltage.

15. The method of claims 12 to 14, further comprising:
enabling, in the image sensor, a rolling shutter mode;
resetting, for each pixel array, the corresponding charge storage device;
accumulating, during a respective integration period, charge within each of the light-sensing elements of the pixels arrays;
for each light sensing-element in a respective pixel array, in sequence:
transferring accumulated charge the respective light-sensing element to the corresponding charge storage device to store as a signal voltage; and
transferring, for each pixel array, the signal voltage from the corresponding charge storage device to a column output line,
and/or wherein each pixel array comprises four light-sensing elements arranged in a 2x2 grid.
